# EUROPEAN PATENT APPLICATION

(11) **EP 3 982 218 A1**
(43) Date of publication of application: **13.04.2022**
(21) Application number: 19932584.6
(22) Date of filing: 14.06.2019
(51) Int. Cl.: G05B 19/418

(54) **PRODUCTION DESIGN ASSISTANCE DEVICE, PRODUCTION DESIGN ASSISTANCE METHOD AND PRODUCTION DESIGN ASSISTANCE PROGRAM**

(30) Priority: 10.06.2019 JP 2019108281
(71) Applicant: Lexer Research Inc., Tottori-shi, Tottori 680-0911 (JP)
(72) Inventor: NAKAMURA Masahiro, Tottori-shi Tottori 680-0911 (JP)
(74) Representative: Murgitroyd & Company
(86) International application number: PCT/JP2019/023626
(87) International publication number: WO 2020/250411

(57) **Abstract**

A production design support device 1 stores facility element information composed of specifications of facility elements; stores operation element information composed of specifications of operation elements including triggering conditions of necessary operation elements and an output destination after completion of operation; stores a production line model defined by a combination of components including link information that associates the facility element and the operation element, the facility element information, and the operation element information, or basic data of the production line model including a combination of operation elements and facility elements for which the link information can be set as the component; sets a plurality of pieces of information among changeable specifications in the facility element information, changeable specifications in the operation element information, and changeable link information as variable parameters of a plurality of independent variables to generate a problem space composed of dimensional axes corresponding to the variable parameters; and causes a learning processing unit to execute an analysis process of acquiring an optimum solution or an optimum solution group of a production design using the problem space as a boundary condition. The problem space of the production line is defined easily and accurately, and more accurate optimum solutions and optimum solution groups are obtained by learning based on artificial intelligence.

## Description

### [Technical field]

The present invention includes a production design support device, a production design support method, and a production design support program for supporting recognition and execution of optimal production design regarding an operation of creating tangible and intangible products, in which a variety of defined tasks such as civil engineering work, construction work, chemical plants, agricultural plants, chain restaurants, or warehousing, including the design of a production line composed of elements such as goods, manufacturing machines, and manufacturing workers related to production in the manufacturing industry, transportation means such as transportation workers and forklifts related to logistics, are carried out in association with multiple elements.

### [Background Art]

Conventionally, a production system simulation device of PTL 1 is known as a support device that supports optimum production design. This device is a device that simulates the state progress caused by a chain of events that occur in a discrete manner. The device stores facility element information that is the specification of a facility element, operation element information including triggering conditions of operation elements and an output destination after completion of an operation, and link information between a facility element and an operation element. The device performs simulation processing so that the facility element executes an operation when the triggering condition of the operation element information of the operation element linked to the facility element by the link information is satisfied, and the execution result is output to an output destination after completion of the operation of the operation element information of the operation element.

The device of PTL 1 performs simulation processing by setting the operation element information of operation elements, which does not change regardless of the capacity and the number of facility elements, independently from the facility element information and setting desired links. In this way, a facility element that performs an operation can be easily and flexibly set and changed, and various simulation conditions and optimum process conditions can be searched for quickly and at a low cost.

### [Citation List]

### [Patent Literature]

PTL 1: Japanese Patent No. 5688864

### [Summary of Invention]

### [Technical Problem]

By the way, in recent years, attempts have been made to derive optimum solutions in various fields using the techniques of machine learning, reinforcement learning, and deep reinforcement learning called artificial intelligence (AI). However, in order to apply the learning technique based on artificial intelligence, it is necessary to define the problem space. The problem space is boundary conditions as the framework of the problem, operation rules, characteristic data of each element, and the like. Since it is impossible to apply learning based on artificial intelligence without the problem space, engineers called data scientists have so far performed learning processing after supplementing the information of the problem space.

Once the problem space is clarified, it is easy to process the problem by the learning technology based on artificial intelligence. For example, the reason why the famous "Alpha Go" could be developed in advance is that the frontier of the world of Igo called "Checkers of Igo" and the definitions, as the operation rules, of "placing stones in order", "the opponent's stone and your own stone are distinguished", "you can take the opponent's stone by surrounding the opponent's stone", "if you make an eye shape, the opponent's stone cannot invade and your eye shape is alive" are given as the frame in the world of Go in the first place. That is, the problem space for solving the solution, which is necessary when the problem is mounted on a learning system, is given in the first place.

However, in the production line of the manufacturing industry, the problem space is usually individual for each company and each production line. In addition, since the problem space is not defined in the first place, it is necessary to newly define the problem space by the personal processing of the data scientist when trying to apply the learning technology based on artificial intelligence to the problem of the production line in the manufacturing industry. These problems are called "frame problems" in the artificial intelligence technology. Therefore, in the manufacturing industry, the introduction of a learning system based on artificial intelligence is limited to a limited range in which the problem space is easily defined, such as predictive maintenance that predicts destruction from the operation history of a target machine facility.

The present invention is proposed in view of the above problems, and an object thereof is to provide a production design support device, a production design support method, and a production design support program capable of easily and accurately defining a problem space of a production line, which is not normally defined, without depending on the personal definition processing of data scientists and obtaining a more accurate optimum solution or optimum solution group by learning based on artificial intelligence based on the problem space.

### [Solution to Problem]

A production design support device of the present invention includes: a facility element information storage unit that stores facility element information composed of specifications of facility elements; an operation element information storage unit that stores operation element information composed of specifications of operation elements including triggering conditions of necessary operation elements and an output destination after completion of operation; and a production line model storage unit that stores a production line model defined by a combination of components including link information that associates the facility element and the operation element, the facility element information, and the operation element information, or basic data of the production line model including a combination of operation elements and facility elements for which the link information can be set as the component, wherein a plurality of pieces of information among changeable specifications in the facility element information, changeable specifications in the operation element information, and changeable link information are set as variable parameters of a plurality of independent variables to generate a problem space composed of dimensional axes corresponding to the variable parameters, and a learning processing unit executes an analysis process of acquiring an optimum solution or an optimum solution group of a production design using the problem space as a boundary condition.

According to this configuration, it is possible to easily and accurately define a problem space of a production line, which is not normally defined, without depending on the personal definition processing of data scientists and obtain a more accurate optimum solution or optimum solution group by learning based on artificial intelligence based on the problem space. In addition, the problem space of a production line with high individuality can be appropriately defined with high flexibility, and excellent versatility is provided. For example, the operation element information of an operation element that is invariable regardless of the capacity and number of facility elements can be set independently of the facility element information, the desired link information can be dynamically set and linked to form a component in cooperation. Therefore, even if the number of facility elements is different, the facility elements and components that carry out an operation of the operation element can be set easily and flexibly and be reflected in the problem space.

In the production design support device of the present invention, the production line model storage unit stores a plurality of production line models defined by a combination of the components corresponding to only a combination of the facility elements and the operation elements that can be executed in a production line, the changeable specifications in the facility element information are set as variable parameters of the plurality of independent variables, or the changeable specifications in the operation element information are set as the variable parameters of the plurality of independent variables, or both are set as the variable parameters of the plurality of independent variables to generate a problem space composed of dimensional axes corresponding to the variable parameters.

According to this configuration, the problem space can be set for all production line models executable in a production line such as a production line executed by the cooperation of a plurality of factories, a production line executed in the whole single factory, or a production line executed in a part of a single factory. The problem space for a production line can be defined more accurately on the basis of various or all possibilities. A still more accurate optimum solution or optimum solution group can be obtained by learning based on artificial intelligence based on the problem space. In addition, it is possible to set the problem space that reflects the individuality of the production line very accurately with the content based on various or all possibilities. For example, various changeable specifications and variable parameters (number of facilities, capacity of facility, element operation time, number of workers involved in the operation, and the like) can be set in the facility element information and operation element information that constitute the component. It is possible to set the problem space that reflects the individuality of a target production line very accurately.

In the production design support device of the present invention, the changeable specifications in the facility element information, the changeable specifications in the operation element information, and the changeable link information are set as the variable parameters of the plurality of independent variables to generate a problem space composed of dimensional axes corresponding to the variable parameters.

According to this configuration, the problem space can be set for all production line models executable in a production line such as a production line executed by the cooperation of a plurality of factories, a production line executed in the whole single factory, or a production line executed in a part of a single factory. The problem space for a production line can be defined more accurately on the basis of various or all possibilities. A still more accurate optimum solution or optimum solution group can be obtained by learning based on artificial intelligence based on the problem space. In addition, it is possible to set the problem space that reflects the individuality of the production line very accurately with the content based on various possibilities. For example, various changeable specifications and variable parameters (number of facilities, capacity of facility, element operation time, number of workers involved in the operation, and the like) can be set in the facility element information and operation element information that constitute the component. It is possible to set the problem space that reflects the individuality of a target production line very accurately. In addition, it is possible to generate and set a highly efficient problem space in the acquisition of an optimum solution and an optimum solution group such as setting the link information corresponding to only a production line model exceeding a predetermined production standard to generate and set the problem space.

In the production design support device of the present invention, production plan information having information on a finished product and changeable specifications are stored in a storage unit, and changeable specifications in the production plan information are set as variable parameters to generate a problem space composed of dimensional axes corresponding to the variable parameters.

According to this configuration, the problem space having the production plan information can also be processed as the target of the learning process, the changeable specifications of the production plan and the variable parameters can be optimized on the basis of the optimum solution or the optimum solution group which is the result of the learning process, and the variable parameters of the production plan information assuming an appropriate production plan, the facility element information, the operation element information, and the link information between facility elements and operation elements can be optimized. In addition, a problem space corresponding to an appropriate or specific production plan can be generated, and a very accurate optimum solution or optimum solution group corresponding to the problem space can be acquired.

In the production design support device of the present invention, a resolution is set to necessary changeable specifications in the facility element information, and changeable specifications in the facility element information, to which the resolution is set, are set as variable parameters of independent variables to generate the problem space having the resolutions of the changeable specifications in the facility element information as additional information.

According to this configuration, when a problem space having the resolution of the changeable specifications in the facility element information as additional information is generated, it is possible to reduce the amount of computation processing for acquiring the optimum solution and the optimum solution group and avoid unnecessary computation processing when acquiring the optimum solution and the optimum solution group.

In the production design support device of the present invention, a resolution is set to necessary changeable specifications in the operation element information, and changeable specifications in the operation element information, to which the resolution is set, are set as variable parameters of independent variables to generate the problem space having the resolutions of the changeable specifications in the operation element information as additional information.

According to this configuration, when a problem space having the resolution of the changeable specifications in the operation element information as additional information is generated, it is possible to reduce the amount of computation processing for acquiring the optimum solution and the optimum solution group and avoid unnecessary computation processing when acquiring the optimum solution and the optimum solution group.

In the production design support device of the present invention, the learning processing unit acquires an optimum solution or an optimum solution group using the problem space as a boundary condition and presents the optimum solution or the optimum solution group to the user, simulation processing is executed on the components of the production line model which is the basis of the problem space so that the facility element executes an operation when the triggering condition of the operation element information of the operation element associated with the facility element by the link information is satisfied and the execution result is output to an output destination after completion of operation of the operation element information of the operation element, and the result of the simulation processing corresponding to the problem space is presented to a user.

According to this configuration, the user can understand the basis for extracting the optimum solution group through the simulation results with respect to the problem that "it is difficult to accept the result due to black-boxing (it is unclear under what background the final solution was derived)" which was a problem in conventional AI processing. It is possible to provide the user with sufficient judgment material, and the user can determine the final optimum solution based on the user's own definite judgment criteria.

In the production design support device of the present invention, the learning processing unit acquires the optimum solution group using the problem space as a boundary condition, simulation processing is executed on the components of the production line model which is the basis of the problem space so that the facility element executes an operation when the triggering condition of the operation element information of the operation element associated with the facility element by the link information is satisfied and the execution result is output to an output destination after completion of operation of the operation element information of the operation element, and the learning processing unit executes a process of acquiring a narrowed optimum solution or a narrowed optimum solution group according to an additional condition corresponding to the result of the simulation processing using the problem space as a boundary condition.

According to this configuration, the accuracy of the learning processing unit of artificial intelligence can be complemented, and a narrowed optimum solution or a narrowed optimum solution group with higher accuracy can be obtained. In addition, when a learning process is performed, production activities that are not actually carried out are virtually realized using production simulation and simulation processing that considers production conditions such as satisfaction of the triggering condition of operation element information. Thus, it is possible to newly learn conditions that have no record related to production. In machine learning, reinforcement learning, and deep reinforcement learning, experience values and evaluation values are used when deriving solution candidate groups, and the solution candidate groups are derived on the basis of the execution results (output) based on the experience values and evaluation values. These pieces of information do not analytically reflect the complex behavior (flow of goods, various production conditions, and the like) in the production line. The learning processing unit acquires the narrowed optimum solution or the narrowed optimum solution group according to the additional condition corresponding to the result of the simulation processing using the problem space as a boundary condition. In this way, the configuration and internal behavior of the production line can be evaluated again, the accuracy is improved, and a reliable optimum solution or narrowed optimum solution group can be obtained.

In the production design support device of the present invention, simulation processing is executed on the components of the production line model which is the basis of the problem space so that the facility element executes an operation when the triggering condition of the operation element information of the operation element associated with the facility element by the link information is satisfied and the execution result is output to an output destination after completion of operation of the operation element information of the operation element, a characteristic condition of the problem space is acquired on the basis of the result of the simulation processing corresponding to at least a part of the problem space, and the learning processing unit executes an analysis process of acquiring an optimum solution or an optimum solution group of a production design according to the characteristic condition using the problem space as a boundary condition.

According to this configuration, the efficiency and accuracy of the learning based on artificial intelligence can be enhanced by analyzing the framework of the problem space in advance by the production simulation by taking the production condition such as satisfaction of the triggering condition of the operation element information into consideration to further optimize the conditions of the analysis process of the learning processing unit. In machine learning, reinforcement learning, and deep reinforcement learning, experience values and evaluation values are used when deriving solution candidates or solution candidate groups, and the solution candidate groups are derived on the basis of the execution results (output) based on the experience values and evaluation values. These pieces of information do not analytically reflect the complex behavior (flow of goods, various production conditions, and the like) in the production line. The learning processing unit acquires the narrowed optimum solution or the narrowed optimum solution group using the problem space and the characteristics of the problem space acquired by simulation processing as conditions. In this way, the configuration and internal behavior of the production line can be evaluated again, the accuracy of the optimum solution or the optimum solution group can be enhanced, and a reliable optimum solution or narrowed optimum solution group can be obtained.

A production design support method of the present invention is a production design support method executed by a computer, including storing facility element information composed of specifications of facility elements; storing operation element information composed of specifications of operation elements including triggering conditions of necessary operation elements and an output destination after completion of operation; storing a production line model defined by a combination of components including link information that associates the facility element and the operation element, the facility element information, and the operation element information, or basic data of the production line model including a combination of operation elements and facility elements for which the link information can be set as the component; setting a plurality of pieces of information among changeable specifications in the facility element information, changeable specifications in the operation element information, and changeable link information as variable parameters of a plurality of independent variables to generate a problem space composed of dimensional axes corresponding to the variable parameters; and causing a learning processing unit to execute an analysis process of acquiring an optimum solution or an optimum solution group of a production design using the problem space as a boundary condition. It should be noted that the content corresponding to the configuration applied in each invention of the production design support device may be applied as the configuration of the production design support method of the present invention.

According to this configuration, it is possible to easily and accurately define a problem space of a production line, which is not normally defined, without depending on the personal definition processing of data scientists and obtain a more accurate optimum solution or optimum solution group by learning based on artificial intelligence based on the problem space. In addition, the problem space of a production line with high individuality can be appropriately defined with high flexibility, and excellent versatility is provided. For example, the operation element information of an operation element that is invariable regardless of the capacity and number of facility elements can be set independently of the facility element information, the desired link information can be dynamically set and linked to form a component in cooperation. Therefore, even if the number of facility elements is different, the facility elements and components that carry out an operation of the operation element can be set easily and flexibly and be reflected in the problem space.

A production design support program of the present invention is a production design support program for causing a computer to function as a production design support device, the program causing the computer to execute: storing facility element information composed of specifications of facility elements; storing operation element information composed of specifications of operation elements including triggering conditions of necessary operation elements and an output destination after completion of operation; storing a production line model defined by a combination of components including link information that associates the facility element and the operation element, the facility element information, and the operation element information, or basic data of the production line model including a combination of operation elements and facility elements for which the link information can be set as the component; setting a plurality of pieces of information among changeable specifications in the facility element information, changeable specifications in the operation element information, and changeable link information as variable parameters of a plurality of independent variables to generate a problem space composed of dimensional axes corresponding to the variable parameters; and causing a learning processing unit to execute an analysis process of acquiring an optimum solution or an optimum solution group of a production design using the problem space as a boundary condition. It should be noted that the content corresponding to the configuration applied in each invention of the production design support device may be applied as the configuration of the production design support program of the present invention.

According to this configuration, it is possible to easily and accurately define a problem space of a production line, which is not normally defined, without depending on the personal definition processing of data scientists and obtain a more accurate optimum solution or optimum solution group by learning based on artificial intelligence based on the problem space. In addition, the problem space of a production line with high individuality can be appropriately defined with high flexibility, and excellent versatility is provided. For example, the operation element information of an operation element that is invariable regardless of the capacity and number of facility elements can be set independently of the facility element information, the desired link information can be dynamically set and linked to form a component in cooperation. Therefore, even if the number of facility elements is different, the facility elements and components that carry out an operation of the operation element can be set easily and flexibly and be reflected in the problem space.

### [Advantageous Effects of Invention]

According to the present invention, it is possible to easily and accurately define a problem space of a production line, which is not normally defined, without depending on the personal definition processing of data scientists and obtain a more accurate optimum solution or optimum solution group by learning based on artificial intelligence based on the problem space.

### [Brief Description of Drawings]

FIG. 1 is a block diagram showing an overall configuration of a production design support device according to a first embodiment of the present invention.
FIG. 2 is a flowchart showing a production design support process by the production design support device of the first embodiment.
FIG. 3 is a flowchart showing a production design support process by a production design support device of a second embodiment.
FIG. 4 is a block diagram showing an overall configuration of a production design support device according to a third embodiment of the present invention.
FIG. 5 is a flowchart showing a production design support process by the production design support device of the third embodiment.
FIG. 6(a) is an explanatory diagram showing a product example in an example of the first embodiment, and FIG. 6(b) is an explanatory diagram showing a flow of a production process in the example.
FIG. 7(a) is an explanatory diagram showing facility elements in an example of the first embodiment, and FIG. 7(b) is a flowchart showing a flow of a production process by operation elements in the example.
FIG. 8 is a diagram showing an example of facility element information stored in a facility element information storage unit in an example of the first embodiment.
FIG. 9 is a diagram showing an example of operation element information stored in an operation element information storage unit in an example of the first embodiment.
FIG. 10(a) is a diagram showing an example of basic data of a production line model stored in a production line model storage unit in an example of the first embodiment, and FIG. 10(b) is a diagram showing an example of the production line model.
FIG. 11 is an explanatory diagram of a problem space in an example of the first embodiment.
FIG. 12 is a diagram showing an example of an optimum solution group obtained in an analysis process of a learning processing unit in an example of the first embodiment.
FIGS. 13(a) to 13(c) are explanatory diagrams showing an example in which the temporal progress of the intermediate inventory based on the log recorded in an operation log database is graphed.
FIG. 14 is an explanatory diagram of a compressed space according to an example of the second embodiment.
FIG. 15 is an explanatory diagram of a compressed space according to an example of the third embodiment.

### [Description of Embodiments]

### [Production design support device and production design support method of first embodiment]

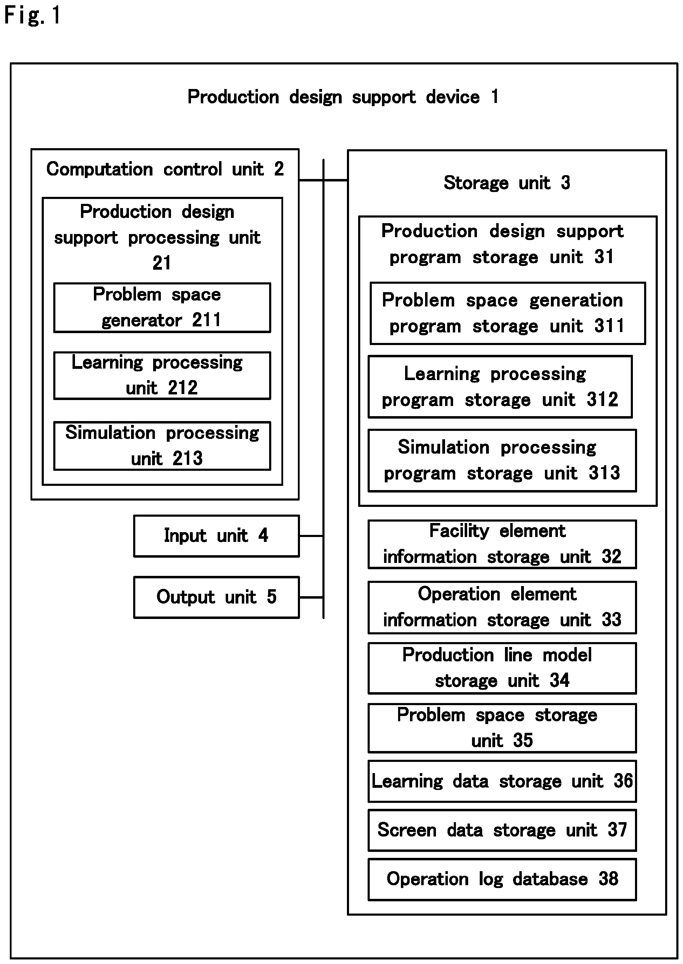

As shown in FIG. 1, a production design support device 1 of a first embodiment according to the present invention includes a computation control unit 2 such as an MPU and a CPU, a storage unit 3 including an HDD, a flash memory, an EEPROM, a ROM, and a RAM, an input unit 4 such as a mouse, a keyboard, and a touch panel, and an output unit 5 such as a display and a printer. The production design support device 1 is realized by a single computer or a computer composed of a collection of a plurality of computer terminals connected by a communication connection network.

The storage unit 3 stores a control program such as a production design support program that causes the computation control unit 2 to execute predetermined processing, and has a production design support program storage unit 31 that stores the production design support program. The production design support program includes a problem space generation program, a learning processing program, and a simulation processing program, and is stored in a problem space generation program storage unit 311, a learning processing program storage unit 312, and a simulation processing program storage unit 313 of the production design support program storage unit 31, which are functionally divided. The production design support program may be composed of a problem space generation program and a simulation processing program, or the production design support program may be composed only of the problem space generation program and be used in combination with a learning processing program different from these production design support programs to execute the production design support process of the present invention.

The computation control unit 2 executes predetermined processing according to the production design support program of the production design support program storage unit 31. The computation control unit 2 in the first embodiment executes the processing as the problem space generation unit 211 according to the problem space generation program of the storage unit 3, executes the processing as the learning processing unit 212 according to the learning processing program, and executes predetermined processing as a simulation processing unit 213 according to a simulation processing program.

The storage unit 3 includes a facility element information storage unit 32 that stores facility element information composed of the specifications of facility elements, an operation element information storage unit 33 that stores operation element information composed of the specifications of operation elements including triggering conditions of the operation elements and an output destination after completion of operations, and a production line model storage unit 34 that stores a production line model defined by a combination of components including link information that associates a facility element and an operation element, the facility element information and the operation element information.

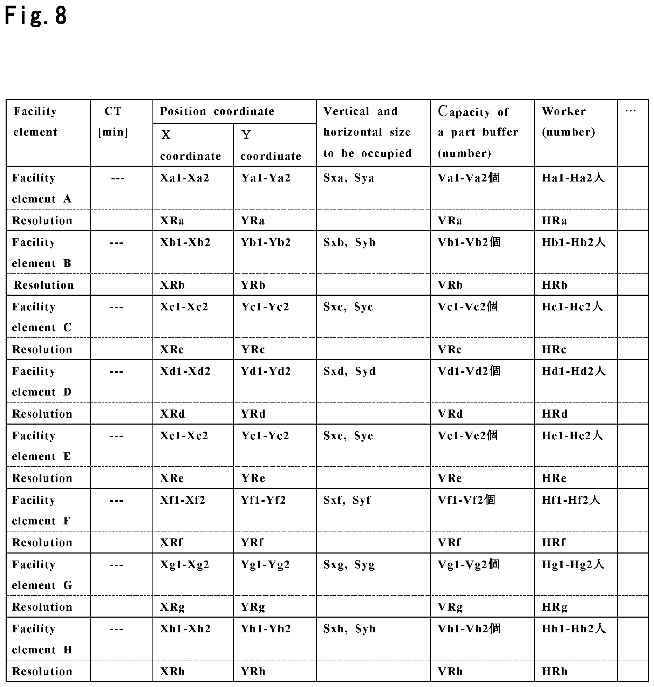

As the specification of a facility element set as the facility element information, an appropriate specification resulting from or related to the facility element itself can be set, and for example, the specification such as the cycle time and the position information of a production facility element is set. Some or all of the specifications of the facility element information are set as a changeable variable parameter, and for example, a specification such as the position information of the production facility element is set as a changeable specification and a variable parameter. It is preferable that the changeable specification or the changeable variable parameter of the facility element information is set as a changeable range of the specification or the variable parameter. Further, it is also possible to describe and modify the data stored in the facility element information storage unit 32 by adding, deleting, and changing the facility element itself, in other words, the facility element information itself. When a facility element is added or changed, the specification of the corresponding facility element is added or changed to the specification of the facility element, and the facility element information is stored in the facility element information storage unit 32. That is, the definition of a facility element to remain and the corresponding facility element information itself is also set as changeable information or a variable parameter. Further, it is preferable that a resolution is set to correspond to all or necessary changeable specifications in the facility element information and is stored in the facility element information storage unit 32 (see FIG. 8).

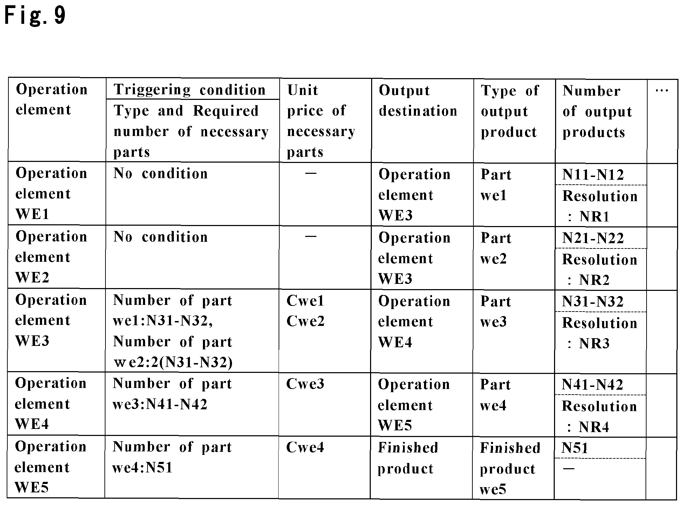

An appropriate specification which is information that does not depend on a facility element, and which is related to a specific operation is set in the operation element information. For example, the number of necessary parts as a triggering condition of an operation element, an output destination after completion of operation, the number of parts to be output, and the like are set as the specifications related to an operation of producing a specific product. The specific operation corresponding to the operation element information includes a part of a series of operations of producing a specific product or the whole series of operations. According to the content or the like of the facility element information of facility elements, a part of a series of operations of producing a specific product or the whole series of operations can be set as the operation element information. However, it is preferable to set a part of a series of operations of producing a specific product as the operation element information. Some or all of the specifications of the operation element information are set as changeable variable parameters. For example, a specification such as the output destination after completion of operation is set as a changeable specification and a variable parameter. It is preferable that the changeable specification or the changeable variable parameter of the operation element information is set as a changeable range of the specification or the variable parameter. Further, it is also possible to describe and modify the data stored in the operation element information storage unit 33 by adding, deleting, and changing the operation element itself, in other words, the operation element information itself. When an operation element is added or changed, the specification of the corresponding operation element is added or changed to the specification of the operation element, and the operation element information is stored in the operation element information storage unit 33. That is, the definition of an operation element and the corresponding operation element information itself is also set as changeable information or a variable parameter. Further, it is preferable that a resolution is set to correspond to all or necessary changeable specifications in the operation element information and is store in the operation element information storage unit 33 (see FIG. 9). In the entire process such as the entire production process, some pieces of operation element information of operation elements of which the triggering condition is not set and stored, such as when an operation element in the first process corresponding to a triggering condition is the starting input, may be included in the operation element information of all operation elements.

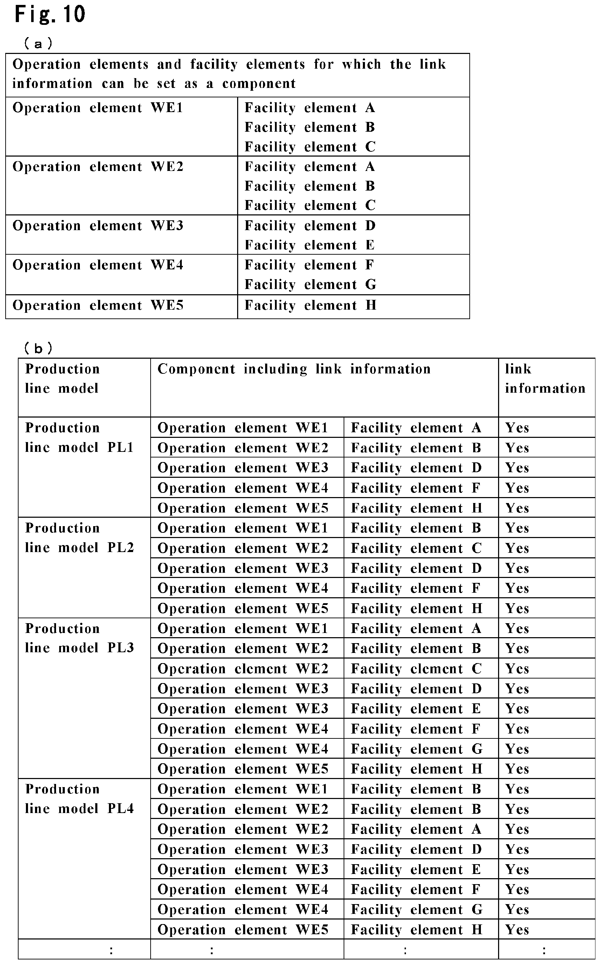

The production line model stored in the production line model storage unit 34 or the like is defined by combination of components including the facility element information of facility elements, the operation element information of operation elements, and the link information that associates the facility element and the facility element (see FIG. 10). The link information of the facility element and the operation element constituting a production line model is set so as to associate the facility element and the operation element. The link information that associates the facility element with the operation element or the link information of the initial condition that associates the facility element with the operation element can be set according to the input from the input unit on a predetermined setting screen displayed on the display of the output unit 5 according to the control of the computation control unit 2 that cooperates with the production design support program, for example. In this way, the production line model is generated and stored. When the link information is set by the input on this setting screen, it is preferable that a screen in which facility elements are arranged two-dimensionally and a screen in which operation elements constituting a production process network are arranged as a network are displayed, elements in the two screens are selected and associated by execution of an association command or drag-and-drop so that the link information can be input and set. By doing so, the link can be set immediately and easily.

As another configuration example, it may be preferable that the computation control unit 2 that cooperates with the production design support program stores a combination of an operation element and a facility element for which the link information can be set as a component in the production line model storage unit 34 as basic data according to the input from the input unit 4 in the setting screen. When a "generate production line model of all combinations" button is designated or input from the input unit 4, the computation control unit 2 generates a plurality of production line models defined by a combination of components corresponding to only the combination of operation elements and facility elements that can be executed in a production line using a combination of operation elements and facility elements for which the link information can be set as the component of the production line model storage unit 34 and stores the generated production line models in the production line model storage unit 34 or in a predetermined area of the storage unit 3.

When a production line model defined by a combination of components corresponding to only the combination of facility elements and operation elements that can be executed in a production line is generated and stored, it is preferable that the production line model set and stored in the production line model storage unit 34 corresponds to only the combination of facility elements and operation elements that can be executed in a production line executed by the cooperation of a plurality of factories, a production line executed in the whole single factory, or a production line executed in a part of a single factory.

As yet another configuration example, it may be preferable that the computation control unit 2 that cooperates with the production design support program stores a combination of operation elements and facility elements for which the link information can be set as a component in the production line model storage unit 34 as basic data according to the input from the input unit 4 in the setting screen. When there is a predetermined input such as "set link information" or "generate problem space" from the input unit 4, the computation control unit 2 generates production line models PL1, PL2, and so on by setting changeable link information as a variable parameter and stores the generated production line models in a predetermined storage area of the storage unit 3 temporarily or continuously. At this time, it may be preferable that the production design support device 1 or the computation control unit 2 generates or extracts only a production line model exceeding a predetermined production standard such as generating or extracting only a production line model of a combination that does not generate a facility element that will be an idle facility. In this configuration example, the link information can be changed, in other words, the associated facility elements and operation elements can be changed.

The storage unit 3 includes a problem space storage unit 35 that stores the problem space (multidimensional solution space) generated by the problem space generation unit 211. On the basis of one or the plurality of production line models stored in the production line model storage unit 34 or the basic data of a production line model including a combination of operation elements and facility elements for which the link information can be set as a component, the problem space generation unit 211 of the computation control unit 2 that cooperates with the problem space generation program generates a problem space composed of dimensional axes corresponding to a variable parameter of an independent variable which is a changeable specification of the facility element information of the component constituting the production line model and a variable parameter of an independent variable which is a changeable specification of the operation element information of the component constituting the production line model, and stores the problem space in the problem space storage unit 35. Or the problem space generation unit 211 generates a problem space composed of dimensional axes corresponding to a variable parameter of an independent variable which is a changeable specification of the facility element information of the component constituting the production line model and a variable parameter of an independent variable which is a changeable specification of the operation element information of the component constituting the production line model and a variable parameter of an independent variable of link information that associates a facility element and an operation element in a changeable manner, and stores the problem space in the problem space storage unit 35.

The storage unit 3 includes a learning data storage unit 36 that stores the data of a learned model or a learning model learned by the data related to a production line including data such as the improvement of an operation rate and the shortening of the manufacturing time. This learned model or learning model is a model that performed or performs machine learning such as reinforcement learning (Q-learning, deep Q-learning, and the like) or ensemble learning, or appropriate learning based on artificial intelligence using a method such as deep learning.

The learning processing unit 212 of the computation control unit 2 that cooperates with the learning processing program executes learning based on artificial intelligence using the learned model or the learning model of the learning data storage unit 36 to execute an analysis process of acquiring an optimum solution or an optimum solution group of the production design while correcting and updating the learned model of the learning data storage unit 36 or generating, correcting, and updating the learning model using the problem space as a boundary condition. For example, when the learning of artificial intelligence in the learning processing unit 212 is Q-learning of reinforcement learning, rewards are calculated on the basis of evaluation values (Q-values) obtained as the result of simulated production (simulated production in the learning process of Q-learning) corresponding to the problem space of the boundary condition, the rewards are accumulated in a Q-network called an agent, and an analysis process of acquiring an optimum solution or an optimum solution group of the production design while correcting and updating the learned model or the learning model on the basis of the accumulated cumulative rewards is executed. For example, when the learning of artificial intelligence in the learning processing unit 212 is deep Q-learning of deep reinforcement learning, rewards are calculated and accumulated from the result of simulated production (simulated production in learning process of deep Q-learning) for a production line model corresponding to the problem space of the boundary condition using deep learning by a convolutional neural network that uses a multi-layer neural network including an input layer, an intermediate layer (convolutional layer, pooling layer), a fully-connected layer, and an output layer, and an analysis process of acquiring an optimum solution or an optimum solution group of the production design while generating, correcting, and updating the learned model or the learning model of the learning data storage unit 36 on the basis of the accumulated cumulative rewards is executed. In addition, when an optimum solution group composed of a plurality of optimum solutions is acquired by these processes, for example, a number of solutions set and stored in the storage unit 3 are extracted in descending order of accumulated cumulative rewards, and are acquired as the optimum solution group. Further, it may be preferable that the processing of the simulated production in the learning process of Q-learning or deep Q-learning by the learning process unit 212 described above is executed by the same processing as the processing of the simulated production in the simulation processing unit 213 described later or by simplifying the processing of simulated production such as to not change predetermined partial variable parameters, for example.

Further, it may be preferable that the production design support device 1 stores information such as the type of a finished product and production plan information having changeable specifications such as the production order and the production start date and time of the finished product in a predetermined storage area of the storage unit 3 such as the problem space generation program storage unit 311 according to the input or the like from the input unit 4. The problem space generation unit 211 generates a problem space composed of dimensional axes corresponding to the variable parameters of the production plan information using the changeable specification of the production plan information as the variable parameter and the learning processing unit 212 executes a learning process using the problem space as a boundary condition. In this way, the problem space having the production plan information can also be processed as the target of the learning process, the changeable specifications of the production plan and the variable parameters can be optimized on the basis of the optimum solution or the optimum solution group which is the result of the learning process, and the variable parameters of the production plan information assuming an appropriate production plan, the facility element information, the operation element information, and the link information between facility elements and operation elements can be optimized. In addition, a problem space corresponding to an appropriate or specific production plan can be generated, and a very accurate optimum solution or optimum solution group corresponding to the problem space can be acquired.

When the learning processing unit 212 executes a learning process on the problem space, it is ideal that the learning process is executed while changing each variable parameter with granularity (fineness) divided by a resolution set for each of a predetermined numerical range of variable parameters, or the learning process is executed while changing a number of variable parameters corresponding to a numerical value set in the predetermined storage area of the storage unit 3 for each granularity (fineness) divided by a predetermined resolution. However, it may be preferable to execute the learning process by setting and applying the same resolution to all or a plurality of variable parameters. It may be preferable that a reference value based on a value determined to be valid in the past is stored in a predetermined storage area of the storage unit 35 such as the problem space storage unit 35 as a reference value of a necessary variable parameter, and a resolution corresponding to the reference value and a numerical range around the reference value are stored in a predetermined storage area of the storage unit 35 such as the problem space storage unit 35. When the learning processing unit 212 executes a learning process on the variable parameter having the reference value, the resolution corresponding to the reference value and the numerical range therearound are applied preferentially, and computation processing is executed on the variable parameter on the basis of the resolution set to the numerical range around the reference value. According to this configuration, since a value determined to be valid in the past is used as a reference value, it can be used as an effective means and a clue when searching for the problem space, and the optimum solution and the optimum solution group can be obtained effectively while narrowing the range of the problem space processed by the learning processing unit 212 to reduce the processing amount.

The storage unit 3 has a screen data storage unit 37 that stores the data of a predetermined screen displayed on the display of the output unit 5, and an operation log database 38 that stores an operation log of state changes in each facility element in correlation with time. Further, the storage unit 4 includes an area for storing data necessary for performing a problem space generation process by the problem space generation unit 211, a learning process by the learning processing unit 212, and a predetermined simulation processing of discrete simulation by the simulation processing unit 213.

The simulation processing unit 213 of the computation control unit 2 that cooperates with the simulation processing program executes simulative computation processing on the state progress of the production process due to the chain of events that occur in a discrete manner. The simulation processing unit 213 executes simulation processing so that a facility element executes an operation on the components (the link information that associates a facility element and an operation element, the facility element information of the facility element, and the operation element information of the operation element) of a production line model which is the basis of the problem space stored in the problem space storage unit 35 when the triggering condition of the operation element information of the operation element associated with the facility element by the link information is satisfied and the execution result is output to an output destination after completion of operation of the operation element information of the operation element. That is, on the premise that the triggering condition and the output destination after completion of operation are set as the operation element information of the operation element, the simulation processing unit 213 triggers the operation of the facility element so that the facility element executes an operation defined in the operation element information of the operation element when the triggering condition of the operation element information of the operation element associated with the facility element by the link information is satisfied, and outputs an intermediate product after completion of operation to the output destination of the operation element information to proceed with the computation.

In the computation processing of the simulation processing unit 213, for example, the triggering condition and the output destination of the operation element information of the operation element associated with the facility element during the computation are referred to, and the operation of the facility element is triggered and output when the triggering condition is satisfied. Alternatively, the triggering condition and the output destination of the operation element information of the operation element associated with the facility element are stored in the storage unit 3 as additional information of the facility element before the computation, and the operation of the facility element is triggered and output when the triggering condition of the operation element information set as the additional information is satisfied. Further, it is ideal from the perspective of accuracy that the simulated computation processing for production of the simulation processing unit 213 is executed for all executable productions by changing the components of one or a plurality of production line models which is the basis of the problem space or the basic data including a combination of operation elements and facility elements from which the link information can be set as the component according to a resolution when the resolution is set and within a range where the variable parameters which are changeable specifications of the facility element information and the changeable specifications of the operation element information or the changeable specifications of the facility element information, the changeable specifications of the operation element information, and the variable parameters of the link information that associates changeable facility elements and changeable operation elements can be changed. When a plurality of production line models is set on the basis of the problem space, it is ideal from the perspective of efficiency of the computation processing and the efficiency of processing corresponding to the purpose of the simulation processing that the simulation processing is executed corresponding to a part of the problem space such as executing so as to correspond to only some production line models.

Further, preferably, the position information of the facility element is stored in the facility element information storage unit 32 as the specification of the facility element. In the computation processing of the simulation processing unit 213, simulation processing is performed such that a transport time from a first facility element to a second facility element based on the position information of the first facility element and the position information of the second facility element which is an output destination of the first facility element is acquired, and an intermediate product after completion of operation of the first facility element is output to the second facility element at a time when the transport time has elapsed from the operation completion time of the first facility element. By doing so, a more accurate process simulation result taking a transport time into consideration can be obtained.

The transport time can be acquired as follows. For example, a coordinate system that defines the entire area of a production factory or the like and a setting speed are stored in a predetermined area of the storage unit 3. In the computation processing of the simulation processing unit 213, the transport time is computed and acquired from the position information of the first facility element, the position information of the second facility element, and the setting speed. Alternatively, a moving route of the computation processing of the simulation processing unit 213 is predicted using a known route prediction technology and predetermined data stored in the predetermined area of the storage unit 3, and the transport time from the first facility element to the second facility element is calculated and acquired on the basis of the moving route.

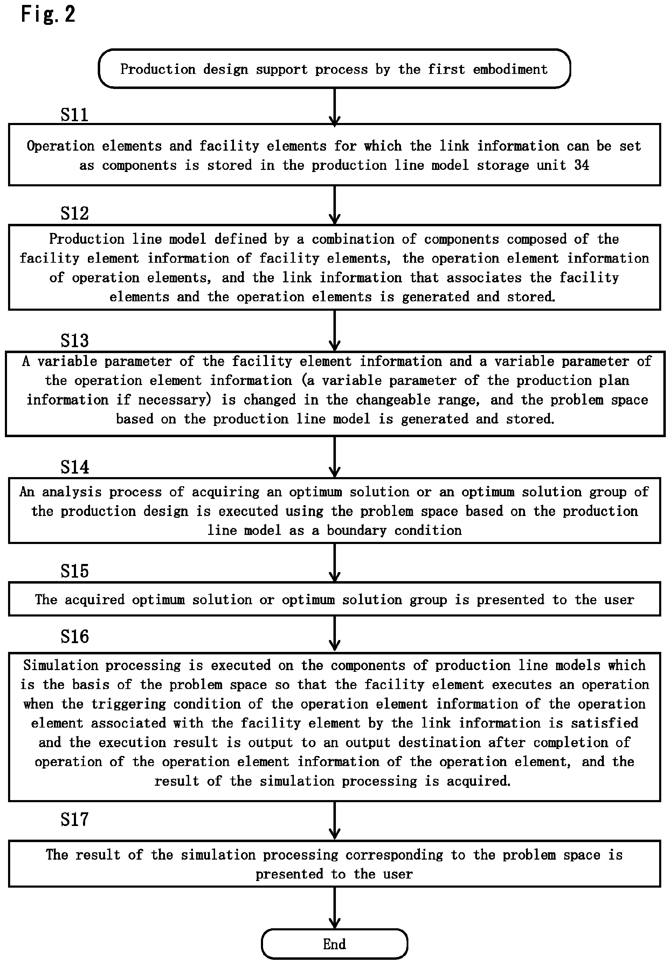

In the production design support process by the production design support device 1 of the first embodiment, as shown in FIG. 2, the combination of operation elements and facility elements for which the link information can be set as components is stored in the production line model storage unit 34 as the basic data of the production line model defined by a combination of components composed of the link information that associates facility elements and operation elements, the facility element information, and the operation element information (S11). Then, the computation control unit 2 that cooperates with the production design support program generates a production line model defined by a combination of components composed of the facility element information of facility elements, the operation element information of operation elements, and the link information that associates the facility elements and the operation elements using the basic data and stores the same (S12). This process can be executed as a process of generating a plurality of production line models defined by a combination of components corresponding to only the combination of facility elements and operation elements executable in the production line and storing the same in the storage unit 3 such as the production line model storage unit 34. This process can be executed by the computation control unit 2 or the problem space generation unit 211. Alternatively, the process can be executed as a process of generating a production line model by setting changeable link information as a variable parameter and storing the same in a predetermined storage area of the storage unit 3 temporarily or continuously.

Subsequently to or in parallel with this process, on the basis of one or the plurality of production line models stored in the production line model storage unit 34 or the basic data of a production line model including a combination of operation elements and facility elements for which the link information can be set as a component, the problem space generation unit 211 generates a problem space composed of dimensional axes corresponding to a variable parameter of an independent variable which is a changeable specification of the facility element information of the component constituting the production line model and a variable parameter of an independent variable which is a changeable specification of the operation element information of the component constituting the production line model, and stores the problem space in the problem space storage unit 35. Or the problem space generation unit 211 generates a problem space composed of dimensional axes corresponding to a variable parameter of an independent variable which is a changeable specification of the facility element information of the component constituting the production line model and a variable parameter of an independent variable which is a changeable specification of the operation element information of the component constituting the production line model and a variable parameter of an independent variable of link information that associates a facility element and an operation element in a changeable manner, and stores the problem space in the problem space storage unit 35 (S13). At this time, when the resolution is set corresponding to all or necessary changeable specifications in the facility element information and operation element information and is stored in the facility element information storage unit 32 and the operation element information storage unit 33, a problem space having the resolution of the changeable specifications in the facility element information and the operation element information as additional information is generated and the additional information of the resolution is stored in the problem space storage unit 35 so as to correspond to the dimensional axis of the corresponding variable parameter. Then, the learning processing unit 212 executes an analysis process of acquiring an optimum solution or an optimum solution group of the production design while correcting and updating the learned model using the generated problem space stored in the problem space storage unit 35 as a boundary condition and stores the acquired optimum solution or optimum solution group in the predetermined storage area of the storage unit 3 (S14). The computation control unit 2 outputs the acquired optimum solution or optimum solution group from the output unit 5 and presents the same to the user (S 15).

Further, the simulation processing unit 213 executes simulation processing on the components of one or a plurality of production line models which is the basis of the problem space so that the facility element executes an operation when the triggering condition of the operation element information of the operation element associated with the facility element by the link information is satisfied, and the execution result is output to an output destination after completion of operation of the operation element information of the operation element, acquires the result of the simulation processing, and stores the result in the predetermined storage area of the storage unit 3 (S16). The computation control unit 2 or the simulation processing unit 213 outputs the result of the simulation processing corresponding to the problem space from the output unit 5 and presents the same to the user (S17).

According to the first embodiment, it is possible to easily and accurately define a problem space of a production line, which is not normally defined, without depending on the personal definition processing of data scientists and obtain a more accurate optimum solution or optimum solution group by learning based on artificial intelligence based on the problem space. In addition, the problem space of a production line with high individuality can be appropriately defined with high flexibility, and excellent versatility is provided. For example, the operation element information of an operation element that is invariable regardless of the capacity and number of facility elements can be set independently of the facility element information, the desired link information can be dynamically set and linked to form a component in cooperation. Therefore, even if the number of facility elements is different, the facility elements and components that carry out an operation can be set easily and flexibly and be reflected in the problem space.

In addition, the problem space can be set for all production line models executable in a production line such as a production line executed by the cooperation of a plurality of factories, a production line executed in the whole single factory, or a production line executed in a part of a single factory. The problem space for a production line can be defined more accurately on the basis of various or all possibilities. A still more accurate optimum solution or optimum solution group can be obtained by learning based on artificial intelligence based on the problem space. In addition, it is possible to set the problem space that reflects the individuality of the production line very accurately with the content based on various or all possibilities. For example, various changeable specifications and variable parameters (number of facilities, capacity of facility, element operation time, number of workers involved in the operation, and the like) can be set in the facility element information and operation element information that constitute the component. It is possible to set the problem space that reflects the individuality of a target production line very accurately. In addition, when the problem space is generated using the link information as a variable parameter, for example, it is possible to generate and set a highly efficient problem space in the acquisition of an optimum solution and an optimum solution group such as setting the link information corresponding to only a production line model exceeding a predetermined production standard to generate and set the problem space.

Further, when a problem space having the resolution of the changeable specifications in the facility element information and the operation element information as additional information is generated, it is possible to reduce the amount of computation processing for acquiring the optimum solution and the optimum solution group and avoid unnecessary computation processing when acquiring the optimum solution and the optimum solution group. In addition, the user can understand the basis for extracting the optimum solution group through the simulation results with respect to the problem that "it is difficult to accept the result due to black-boxing (it is unclear under what background the final solution was derived)" which was a problem in conventional AI processing. It is possible to provide the user with sufficient judgment material, and the user can determine the final optimum solution based on the user's own definite judgment criteria.

### [Production design support device and production design support method of second embodiment]

The basic configuration of the production design support device 1 of the second embodiment according to the present invention is the same as that of the first embodiment (see FIG. 1). However, the learning processing unit 212 of the computation control unit 2 that cooperates with the learning processing program executes an analysis process of acquiring an optimum solution group which is a solution candidate group of production design while correcting and updating a learned model using the problem space based on one or a plurality of production line models as a boundary condition using an appropriate learning technology based on artificial intelligence such as deep Q-learning as in the first embodiment to acquire the optimum solution group. The process of the learning processing unit 212 acquiring the optimum solution group composed of a plurality of optimum solutions is performed by basically the same learning process as in the first embodiment. For example, the process involves extracting a number of solutions corresponding to the number set in the storage unit 3 in descending order of accumulated cumulative rewards or extracting solutions in which the accumulated cumulative reward exceeds a threshold stored in the storage unit 3 and acquiring these solutions as the optimum solution group. Further, the learning processing unit 212 performs computations by basically the same learning process as in the first embodiment, and executes a process of acquiring a narrowed optimum solution or a narrowed optimum solution group using the problem space as a boundary condition and using the result of simulation processing as an additional condition.

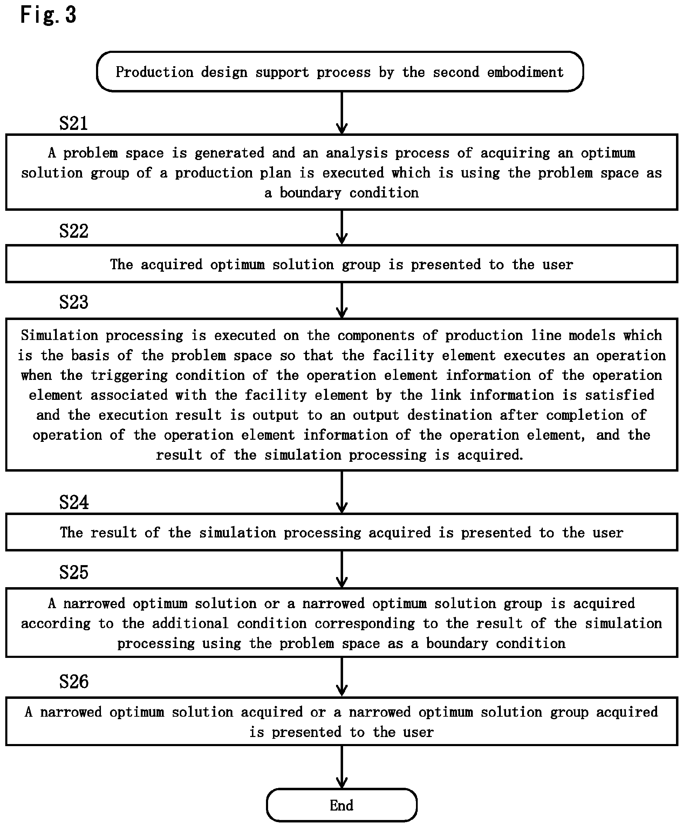

In the production design support process by the production design support device 1 of the second embodiment, as shown in FIG. 3, the computation control unit 2 that cooperates with the production design support program generates and stores a problem space, executes an analysis process of acquiring an optimum solution group which is a solution candidate group of a production design using the problem space as a boundary condition, stores the optimum solution group in a predetermined storage area of the storage unit 3 (S21) and presents the acquired optimum solution group to the user (S22). The production design support process by the computation control unit 2 up to this point is performed in the same process as in the first embodiment, and the configuration of the hardware resource as the premise thereof is also the same as in the first embodiment.

Further, similarly to the simulation processing of the first embodiment, the simulation processing unit 213 executes simulation processing on the components of one or a plurality of production line models which is the basis of the problem space so that the facility element executes an operation when the triggering condition of the operation element information of the operation element associated with the facility element by the link information is satisfied, and the execution result is output to an output destination after completion of operation of the operation element information of the operation element, acquires the result of the simulation processing, and stores the result in the predetermined storage area of the storage unit 3 (S23). The computation control unit 2 or the simulation processing unit 213 outputs the result of the simulation processing corresponding to the problem space from the output unit 5 and presents the same to the user (S24). The configuration of the hardware resource that is the premise of this simulation processing is also the same as that of the first embodiment.

After that, the learning processing unit 212 executes a process of acquiring a narrowed optimum solution or a narrowed optimum solution group while correcting and updating a learned model according to the additional condition corresponding to the result of the simulation processing using the problem space as a boundary condition and stores the narrowed optimum solution or the narrowed optimum solution group in the predetermined storage area of the storage unit 3 (S25). The computation control unit 2 outputs the acquired narrowed optimum solution or narrowed optimum solution group from the output unit 5 and presents the same to the user (S26). It is preferable that the additional condition corresponding to the result of this simulation processing is set in a predetermined storage area of the storage unit 3 of the production design support device 1 according to the input from the input unit 4, for example, on the basis of the result of the simulation processing. It may be preferable that the upper and lower thresholds or the upper and lower thresholds per unit time are set in the predetermined storage area of the storage unit 3 of the production design support device 1. When the computation control unit 2 that cooperates with the production design support program of the production design support device 1 detects an index such as a facility operation rate exceeding or below this threshold, a fluctuation of the intermediate stock, and a temporal progress of the fluctuation of the intermediate stock as the result of the simulation processing, the computation control unit 2 of the production design support device 1 automatically sets an additional condition corresponding to the result of the simulation processing such as setting a condition that the index is within a threshold as the additional condition. It may be ideal that, when the additional condition is automatically set, the presentation of the optimum solution group and the result of the simulation processing to the user or the presentation of the result of the simulation processing to the user is omitted. In addition, for the process of computing, acquiring and presenting the narrowed optimum solution group composed of a plurality of narrowed optimum solutions and the hardware configuration that is the premise thereof, the process of computing, acquiring and presenting the optimum solution group and the learning process configuration corresponding to the hardware configuration that is the premise thereof can be used. Further, the narrowed optimum solution and the narrowed optimum solution group may be solutions in the optimum solution group when there is no additional condition corresponding to the result of the simulation processing, and a part or all of them may be the solution outside the optimum solution group.

According to the second embodiment, the corresponding effect can be obtained from the configuration corresponding to the first embodiment, the accuracy of the learning processing unit 212 of artificial intelligence can be complemented, and a narrowed optimum solution or a narrowed optimum solution group with higher accuracy can be obtained. In addition, when a learning process is performed, production activities that are not actually carried out are virtually realized using production simulation and simulation processing that considers production conditions such as satisfaction of the triggering condition of operation element information. Thus, it is possible to newly learn conditions that have no record related to production. In machine learning, reinforcement learning, and deep reinforcement learning, experience values and evaluation values are used when deriving solution candidate groups, and the solution candidate groups are derived on the basis of the execution results (output) based on the experience values and evaluation values. These pieces of information do not analytically reflect the complex behavior (flow of goods, various production conditions, and the like) in the production line. The learning processing unit 212 acquires the narrowed optimum solution or the narrowed optimum solution group according to the additional condition corresponding to the result of the simulation processing using the problem space as a boundary condition. In this way, it is possible to re-evaluate the configuration and internal behavior of the production line, improve the accuracy and obtain a reliable optimum solution or narrowed optimum solution group.

### [Production design support device and production design support method of third embodiment]

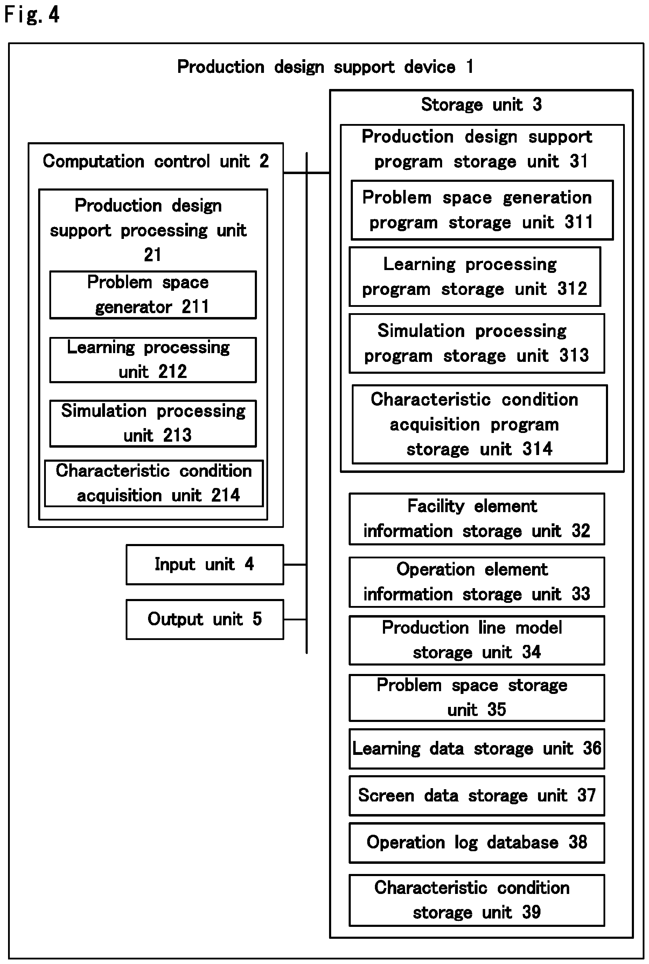

The basic configuration of the production design support device 1 of the third embodiment according to the present invention is the same as that of the first embodiment. However, as shown in FIG. 4, the production design support program includes a problem space generation program, a learning processing program, a simulation processing program, and a characteristic condition acquisition program, which are stored in a problem space generation program storage unit 311, a learning processing program storage unit 312, a simulation processing program storage unit 313, and a characteristic condition acquisition program storage unit 314 of a production design support program storage unit 31, which are functionally divided, and a characteristic condition storage unit 39 is provided in the storage unit 3. The production design support program may include a problem space generation program, a simulation processing program, and a characteristic condition acquisition program, and may be used in combination with a learning processing program different from this production design support program to execute the production design support process of the present invention.

The computation control unit 2 executes a predetermined process according to the production design support program of the production design support program storage unit 31. The computation control unit 2 in the third embodiment can execute the same processing as in the first embodiment, and also executes predetermined processing as the characteristic condition acquisition unit 214 according to the characteristic generation program. Then, the simulation processing unit 213 executes simulation processing on the components of one or a plurality of production line models which is the basis of a problem space corresponding to at least a part of the problem space so that the facility element executes an operation when the triggering condition of the operation element information of the operation element associated with the facility element by the link information is satisfied, and the execution result is output to an output destination after completion of operation of the operation element information of the operation element, acquires the result of the simulation processing, and stores the result of the simulation processing in the predetermined storage area of the storage unit 3. In this simulation processing, it may be preferable that simulation processing is executed on a partial region of the problem space, for example, such that simulation processing is executed while fixing arbitrary variable parameters of the changeable specifications of the facility element information and the changeable specifications of the operation element information and changing the remaining variable parameters.

Further, the characteristic condition acquisition unit 214 of the computation control unit 2 that cooperates with the characteristic condition acquisition program generates a characteristic condition of the problem space on the basis of the result of the simulation processing corresponding to at least a part of the problem space, and stores the characteristic condition in the characteristic condition storage unit 39. When generating the characteristics of the problem space based on the result of the simulation processing, it may be preferable that the upper and lower thresholds or the upper and lower thresholds per unit time are set in the predetermined storage area of the storage unit 3 of the production design support device 1. When the characteristic condition acquisition unit 214 detects an index such as a facility operation rate exceeding or below this threshold, a fluctuation of the intermediate stock, and a temporal progress of the fluctuation of the intermediate stock as the result of the simulation processing, the characteristic condition acquisition unit 214 acquires a condition that the index is within a threshold as the characteristic condition, and stores the characteristic condition in the characteristic condition storage unit 39.

As another example, for example, it may be preferable that a threshold range for the degree of difference or the fluctuation rate of a required index of the result of the simulation processing is set in a predetermined storage area of the storage unit 3 of the production design support device 1, and the simulation processing unit 213 acquires a plurality of simulation processes in which the variable parameters of the changeable specification of the facility element information and the changeable specification of the operation element information are changed stepwise. The characteristic condition acquisition unit 214 acquires a combination of variable parameters corresponding to the results of two simulation processes in which the degree of difference or the fluctuation rate of a required index such as the degree of difference of a temporal progress graph showing the fluctuation in the intermediate inventory in the results of the plurality of simulation processes is within the threshold and the values of the variable parameters are the closest, acquires a characteristic condition in which the difference between the values of variable parameters in the combination of the two variable parameters is used as the resolution of the variable parameters, and stores the characteristic condition in the characteristic condition storage unit 39, and sets the characteristic condition of the resolution as the additional information of the problem space. Further, if necessary, it may be preferable that necessary characteristic conditions such as the above-mentioned characteristic conditions based on the result of the simulation processing are input from the input unit 4, the characteristic condition acquisition unit 214 recognizes and acquires the input characteristic conditions, and the characteristic conditions are stored in the characteristic condition storage unit 39.

The learning processing unit 212 of the computation control unit 2 that cooperates with the learning processing program executes learning based on artificial intelligence using the learned model or the learning model of the learning data storage unit 36 to execute an analysis process of acquiring an optimum solution or an optimum solution group of the production design while correcting and updating the learned model of the learning data storage unit 36 according to the characteristic condition using the problem space as a boundary condition. The learning processing unit 212 executes the same processing as in the first embodiment except that the analysis process is executed according to the characteristic conditions.

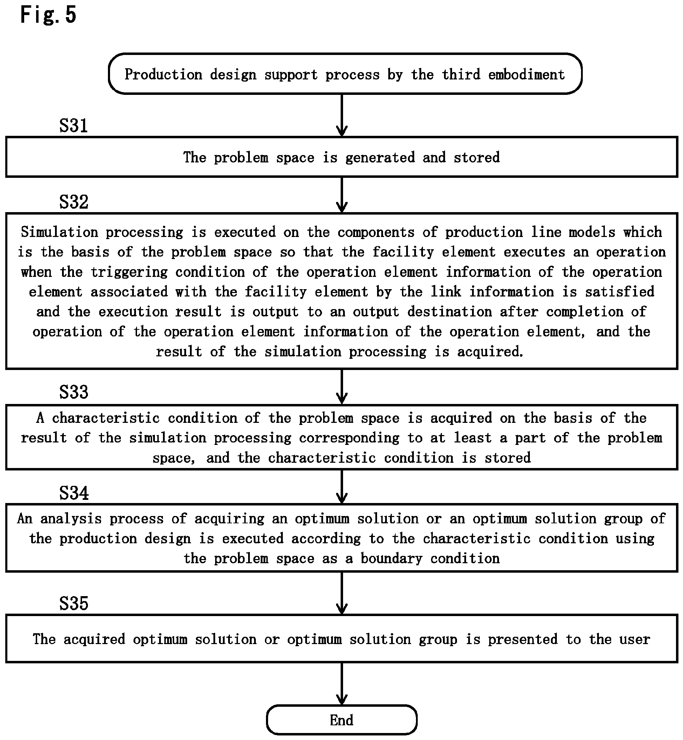

In the production design support process by the production design support device 1 of the third embodiment, as shown in FIG. 5, the problem space generation unit 211 generates the problem space by performing the same process as in the first and second embodiments and stores the problem space in the problem space storage unit 35 (S31). Then, the simulation processing unit 213 executes simulation processing on the components of one or a plurality of production line models which is the basis of a problem space corresponding to at least a part of the problem space so that the facility element executes an operation when the triggering condition of the operation element information of the operation element associated with the facility element by the link information is satisfied, and the execution result is output to an output destination after completion of operation of the operation element information of the operation element, acquires the result of the simulation processing, and stores the result of the simulation processing in the predetermined storage area of the storage unit 3 (S32). This simulation processing method can be executed by the same processing as in the first embodiment.

After that, the characteristic condition acquisition unit 214 acquires a characteristic condition of the problem space on the basis of the result of the simulation processing corresponding to at least a part of the problem space, and stores the characteristic condition in the characteristic condition storage unit 39 (S33). Then, the learning processing unit 212 execute an analysis process of acquiring an optimum solution or an optimum solution group of the production design while correcting and updating the learned model of the learning data storage unit 36 according to the characteristic condition using the problem space as a boundary condition and stores the acquired optimum solution or optimum solution group in the predetermined storage area of the storage unit 3 (S34). The same process as in the first embodiment can be executed for the process of acquiring the optimum solution group. Further, the computation control unit 2 outputs the acquired optimum solution or optimum solution group from the output unit 5 and presents the same to the user (S35).

According to the third embodiment, the corresponding effect can be obtained from the configuration corresponding to the first embodiment, and the efficiency and accuracy of the learning based on artificial intelligence can be enhanced by analyzing the framework of the problem space in advance by the production simulation to further optimize the conditions of the analysis process of the learning processing unit 212. In machine learning, reinforcement learning, and deep reinforcement learning, experience values and evaluation values are used when deriving solution candidates or solution candidate groups, and the solution candidate groups are derived on the basis of the execution results (output) based on the experience values and evaluation values. These pieces of information do not analytically reflect the complex behavior (flow of goods, various production conditions, and the like) in the production line. The learning processing unit 212 acquires the optimum solution or the optimum solution group using the problem space and the characteristics of the problem space acquired by simulation processing as conditions. In this way, the configuration and internal behavior of the production line can be evaluated again, the accuracy of the optimum solution or the optimum solution group can be enhanced, and a reliable optimum solution or narrowed optimum solution group can be obtained.

### [Examples]

### [Example of first embodiment]

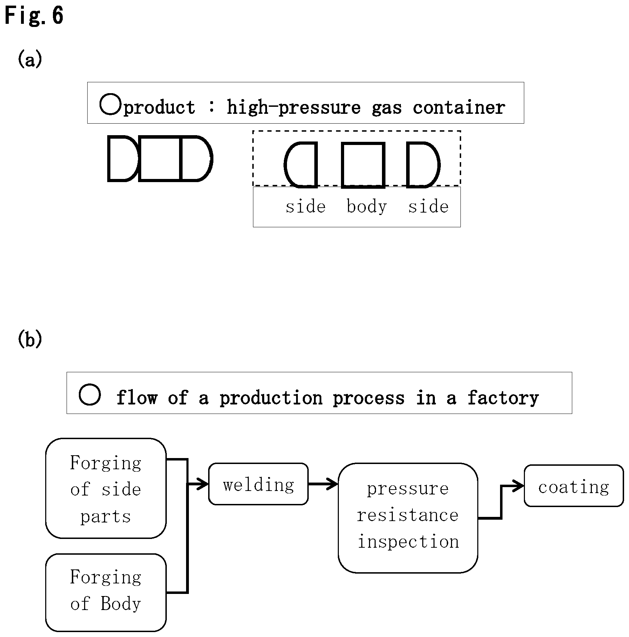

Next, an example in which the production design support device 1 of the first embodiment is applied to a production process and a production operation of manufacturing a high-pressure gas container as a product will be described. As shown in FIG. 6, the example shows a production process in which the high-pressure gas container is formed by fixing a body (Body) and side parts (Side) on both sides, and the body (Body) and the side parts (Side) on both sides are forged. After that, the body (Body) and the side parts (Side) on both sides are welded and subjected to pressure resistant inspection, and then coating is performed to obtain the high-pressure gas container.

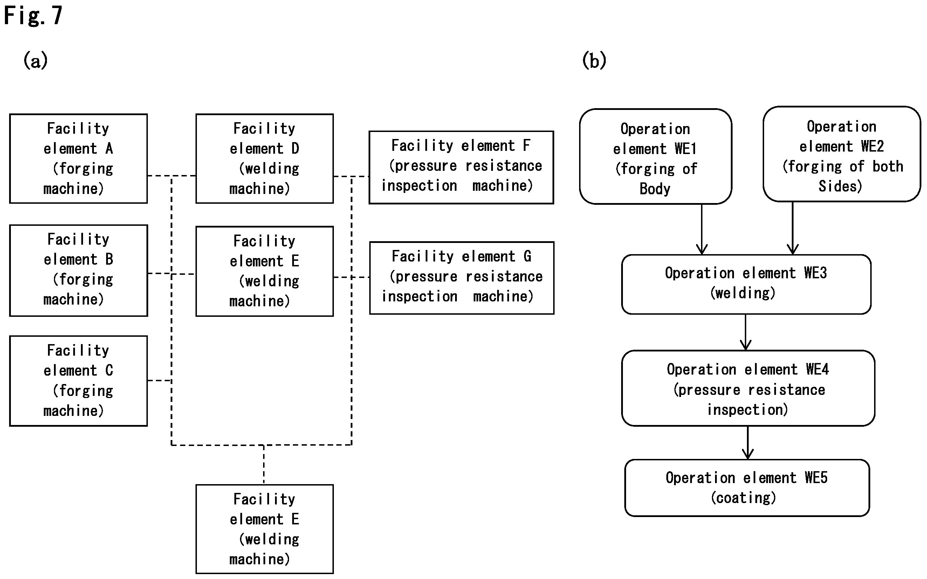

In the production process of this production, the facility elements and the operation elements are defined as production elements as shown in FIG. 7. That is, forging machines are defined as facility elements A to C, welding machines are defined as facility elements D and E, pressure resistance inspection machines are defined as facility elements F and G, and a coating machine is defined as facility element H. A body (Body) forging process is defined as an operation element we1, a side part (Side) forming process is defined as an operation element we2, a welding process is defined as an operation element we3, a pressure resistance inspection process is defined as an operation element we4, and a coating process is defined as an operation element we5. Note that FIG. 7 schematically shows the position and passage (dotted line in the drawing) of each station as facility elements in a factory layout.

The production design support device 1 stores facility element information, which is the specification of each facility element, in the facility element information storage unit 32 according to the input from the input unit 4. Some of the specifications of the facility element information of this example are set as changeable specifications, and the changeable specifications and the variable parameters of the facility element information are set as changeable ranges and are stored in the facility element information storage unit 32. Note that all specifications of the facility element information may be set as changeable specifications and variable parameters as necessary, and the existence itself of the facility element information corresponding to a facility element may be changed.

FIG. 8 shows an example of facility element information set for each facility element and stored in the facility element information storage unit 32. In this example, the following facility element information is set for each facility element. For example, the cycle time CT [min] of each product is set as a fixed value, the position coordinate in the coordinate system of the factory layout is set as a variable parameter, the vertical and horizontal dimensions occupied by the facility element are set as a fixed value, the capacity of a part buffer of the facility element is set as a variable parameter, and the number of workers who carry out the operation in the facility element is set as a variable parameter. When the facility element requires a plurality of types of parts, the capacity of the part buffer may be set for each part type. In the example of the facility element A in FIG. 8, the X coordinate of the position coordinate can be changed in the range of Xa1-Xa2 and the Y coordinate can be changed in the range of Ya1-Ya2, the capacity of the part buffer can be changed in the range of Va1-Va2, and the number of workers who carry out operations in the facility element can be changed in the range of Ha1-Ha2.

In FIG. 8, for the changeable specifications and the variable parameters, the resolution or the number of divisions applied in the changeable range are set in the facility element information storage unit 32. For example, the X coordinate of the position coordinate of the facility element A is changed in units of the resolution or number of divisions XRa applied in the changeable range of Xa1-Xa2, the Y coordinate of the position coordinate of the facility element A is changed in units of the resolution or number of divisions YRa applied in the changeable range of Yal-Ya2, the capacity of the facility element A is changed in units of the resolution or number of divisions VRa applied in the changeable range of Va1-Va2, and the number of workers responsible for the operation of the facility element A is changed in units of the resolution or number of divisions HRa applied in the changeable range of Ha1-Ha2. If all resolutions of XRa, YRa, VRa, and HRa of the facility element A are a predetermined number "1", the computation processing of the production design support device 1 or the computation control unit 2 is executed such that the X coordinate of the position coordinate of the facility element A is changed in units of "1" within the changeable range of Xa1-Xa2, the Y coordinate of the position coordinate of the facility element A is changed in units of "1" within the changeable range of Ya1-Ya2, the capacity of the facility element A is changed in units of "1" within the changeable range of Va1-Va2, and the number of workers responsible for the operation of the facility element A is changed in units of "1" within the changeable range of Ha1-Ha2. The predetermined number of this resolution is set to an integer value as necessary according to the content of the specifications and the variable parameters, such as the capacity (number of accommodatable parts) of the facility element A and the number of workers responsible for the operation of the facility element A. The computation processing of the production design support device 1 or the computation control unit 2 may be executed such that the resolution or the number of divisions applied to the required variable parameters in the facility element information is set as a predetermined numerical range, and the resolution or the number of divisions of the numerical value designated from the numerical range is applied. Alternatively, a numerical range may be set at predetermined intervals, and the resolution or number of divisions of the numerical value designated from the numerical range may be applied. Alternatively, all numerical values in the predetermined intervals may be applied to the resolution.

The production design support device 1 stores the operation element information, which is the specification of each operation element, in the operation element information storage unit 33 according to the input from the input unit 4. Some of the specifications of the operation element information of this embodiment are set as changeable specifications and variable parameters, and the changeable specifications and variable parameters of the operation element information are set as a changeable range and stored in the operation element information storage unit 33. Note that all specifications of the operation element information may be set as changeable specifications and variable parameters as necessary, and the existence itself of the operation element information corresponding to the operation element may be changed.

FIG. 9 shows an example of operation element information set for each operation element and stored in the operation element information storage unit 33. In this example, the following operation element information is set for each operation element. For example, the type of necessary parts of the operation element, the required number of necessary parts, and the unit price of necessary parts are set as fixed values or fixed data, the output destination of the operation element is set as a fixed value or fixed data, the type of output product of the operation element is set as a fixed value or fixed data, and the number of output products of the operation element is set as a changeable specification and a variable parameter. In the operation elements we1 and we2, which are the first operation process, the triggering condition of the operation element is not set or the triggering condition of an operation element such as part we0 such as a metal material is set. In the operation elements we3, we4, and we5 corresponding to the subsequent operation process other than the first operation process, the triggering condition of the operation element is set. The triggering condition of the operation elements we3, we4, and we5 corresponding to the subsequent operation process in the example of FIG. 9 is the type and the number of necessary parts corresponding to the number of output products of the operation elements we3, we4, and we5, which are variable parameters. The number of necessary parts is set as a variable parameter that depends on the number of output products of the operation elements we3, we4, and we5. In the example of the operation element we3 in FIG. 9, the number of parts we3 which are output products, which is a variable parameter can be changed in the range of N31-N32, and the number of necessary parts we1 and the number of necessary parts we2 in the triggering condition of the operation element we3, the numbers being dependent to the number of parts we3 can be changed within the ranges of N31-N32 and 2 (N31-N32), respectively. Further, in the example of the operation element we5 in FIG. 9, the number of types of output products of a finished product is a fixed value of N51, and the number of parts we4 required for this is N51, which depends on the number of output products N51. However, the number of types of output products of the finished product may be a variable parameter, and the number of parts required for this may be a variable parameter that depends on the number of types of output products of the finished product.

In FIG. 9, for the changeable specifications and the variable parameters, the resolution or the number of divisions applied in the changeable range is set in the operation element information storage unit 33. For example, the number of output products of the operation element we3 is changed in units of the resolution or number of divisions NR3 applied in the changeable range. If all resolutions of NR1 to NR4 of the operation elements we1 to we4 are a predetermined number "1", the computation processing of the production design support device 1 or the computation control unit 2 is executed such that the numbers of output products of the operation elements we1, we2, we3, and we4 are changed in units of "1" in the changeable range of N11-N12, N21-N22, N31-N32, and N41-N42, respectively. The predetermined number of this resolution is set to an integer value as necessary according to the content of the specifications and the variable parameters. The computation processing of the production design support device 1 or the computation control unit 2 may be executed such that the resolution or the number of divisions applied to the required variable parameters in the operation element information is set as a predetermined numerical range, and the resolution or the number of divisions of the numerical value designated from the numerical range is applied. Alternatively, a numerical range may be set at predetermined intervals, and the resolution or number of divisions of the numerical value designated from the numerical range may be applied. Alternatively, all numerical values in the predetermined intervals may be applied the resolution.

Further, in the production design support device 1, for example, when a "generate production line model of all combinations" button is designated or input from the input unit 4, the computation control unit 2 generates a plurality of production line models defined by a combination of components corresponding to only the combination of operation elements and facility elements that can be executed in a production line and stores the generated production line models in the production line model storage unit 34. Note that the computation control unit 2 of the production design support device 1 may generate one or a plurality of necessary production line models only according to the input of the link information of facility elements and operation elements from the input unit 4 and store the generated production line models in the production line model storage unit 34.

FIG. 10 shows an example of a production line model stored in the production line model storage unit 34. The production line model storage unit 34 stores a combination of operation elements and facility elements for which the link information can be set as a component. The production line model stored in the production line model storage unit 34 is defined by combination of components including the facility element information of facility elements, the operation element information of operation elements, and the link information that associates the facility element and the facility element. In the example of FIG. 10, all production line models PL1, PL2, and so on corresponding to the production lines that can be executed in the entire factory corresponding to FIG. 7 are set and stored in the production line model storage unit 34.

Further, instead of the configuration example of the production line model of FIG. 10, it may be preferable that a combination of operation elements and facility elements for which the link information can be set as a component is stored in the production line model storage unit 34 as the basic data of the production line model defined by a combination of components composed of the link information that associates facility elements and operation elements, the facility element information, and the operation element information. The production design support device or the computation control unit 2 generates production line models PL1, PL2, and so on by setting changeable link information as a variable parameter and stores the generated production line models in the predetermined storage area of the storage unit 3 temporarily or continuously. At this time, it may be preferable that the production design support device 1 or the computation control unit 2 generates or extracts only a production line model exceeding a predetermined production standard such as generating or extracting only a production line model of a combination that does not generate a facility element that will be an idle facility.

On the basis of one or the plurality of production line models stored in the production line model storage unit 34 or the basic data of a production line model including a combination of operation elements and facility elements for which the link information can be set as a component, the problem space generation unit 211 generates a problem space composed of dimensional axes corresponding to a variable parameter of an independent variable which is a changeable specification of the facility element information of the component constituting the production line model and a variable parameter of an independent variable which is a changeable specification of the operation element information of the component constituting the production line model, and stores the problem space in the problem space storage unit 35. Or the problem space generation unit 211 generates a problem space composed of dimensional axes corresponding to a variable parameter of an independent variable which is a changeable specification of the facility element information of the component constituting the production line model and a variable parameter of an independent variable which is a changeable specification of the operation element information of the component constituting the production line model and a variable parameter of an independent variable of link information that associates a facility element and an operation element in a changeable manner, and stores the problem space in the problem space storage unit 35 .

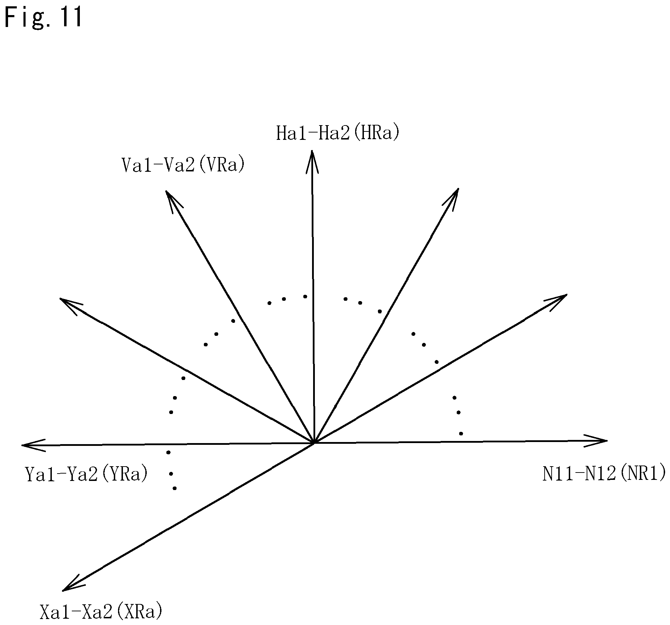

In the examples of FIGS. 8 to 10, the problem space generation unit 211 generates the problem space composed of dimensional axes corresponding to the variable parameters of independent variables which is changeable specification of the operation element information such as the position coordinate in the coordinate system of the factory layout, the capacity of the part buffer of the facility element, and the number of workers who carry out the operation in the facility element, and the variable parameters of independent variables which is changeable specification of the operation element information such as the number of output products of the operation element, and stores the problem space in the problem space storage unit 35. Alternatively, the problem space generation unit 211 generates the problem space composed of dimensional axes corresponding to the variable parameters of independent variables which is changeable specification of the operation element information such as the position coordinate in the coordinate system of the factory layout, the capacity of the part buffer of the facility element, and the number of workers who carry out the operation in the facility element, and the variable parameters of independent variables which is changeable specification of the operation element information such as the number of output products of the operation element, and the variable parameters which are independent variables of the link information that changeably associates facility elements and operation elements, and stores the problem space in the problem space storage unit 35. At this time, when the resolution is set corresponding to all or necessary changeable specifications in the facility element information and operation element information and is stored in the facility element information storage unit 32 and the operation element information storage unit 33, a problem space having the resolution of the changeable specifications in the facility element information and the operation element information as additional information is generated and the additional information of the resolution is stored in the problem space storage unit 35 so as to correspond to the dimensional axis of the corresponding variable parameter (see FIG. 11).

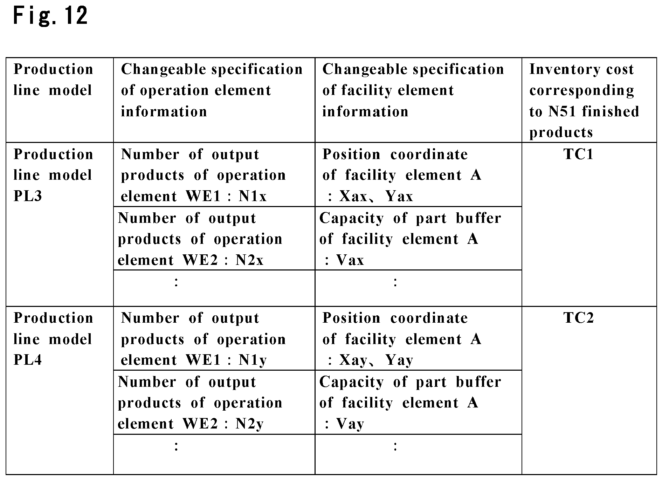

After that, the learning processing unit 212 executes an analysis process of acquiring an optimum solution or an optimum solution group of the production design while correcting and updating the learned model or the learning model using the generated problem space stored in the problem space storage unit 35 as a boundary condition, and the computation control unit 2 that cooperates with the production design support program outputs the acquired optimum solution or optimum solution group from the output unit 5 and presents the same to the user. The learning processing unit 212 in this example executes an analysis process so that, for example, the degree of lack of material inventory or product inventory reaches the degree of the height of the cumulative reward, and further, executes an analysis process so that, for example, the degree of on-time delivery rate and the operation rate of a production line corresponding to an individual order reaches the degree of the height of the cumulative reward. The learning processing unit 212 computes and acquires an inventory cost for combinations of a production line model and the values of each variable parameter of the production line model when manufacturing N51 finished products and acquires a plurality of high-ranking combinations with lower inventory costs such as a predetermined number of combinations set in the predetermined storage area of the storage unit 3 as the optimum solution group. Alternatively, the learning processing unit 212 computes and acquires an inventory cost for combinations of a production line model and the values of each variable parameter of the production line model when manufacturing N51 finished products and acquires a plurality of combinations with inventory costs lower than a threshold inventory cost stored in the predetermined storage area of the storage unit 3 as the optimum solution group. Alternatively, the learning processing unit 212 computes and acquires an inventory cost for combinations of a production line model and the values of each variable parameter of the production line model when manufacturing N51 finished products and acquires a combination with the lowest inventory cost as the optimum solution group. Then, the computation control unit 2 outputs the acquired optimum solution or optimum solution group from the output unit 5 and presents the same to the user with the content as shown in FIG. 12, for example.

Further, the simulation processing unit 213 executes simulation processing on the components of one or a plurality of production line models which is the basis of the problem space so that the facility element executes an operation when the triggering condition of the operation element information of the operation element associated with the facility element by the link information is satisfied, and the execution result is output to an output destination after completion of operation of the operation element information of the operation element, and acquires the result of the simulation processing. The computation control unit 2 that cooperates with the production design support program or the simulation processing unit 213 outputs the result of the simulation processing corresponding to the problem space from the output unit 5 and presents the same to the user. The simulation processing unit 213 in this example executes simulation processing with respect to combinations of the production line model PL3 in FIG. 12 and the values of variable parameters of the production line model PL3, combinations of the production line model PL4 and the values of variable parameters of the production line model PL4, and the combinations extracted in FIG. 12 in which the variable parameters of the facility element information or the variable parameters of the operation element information, or both are changed to predetermined values according to the input from the input unit 4, so that as in PTL 1, operations are executed using parts required by the facility elements when the triggering condition of the operation element information of the operation elements associated with the facility elements by the link information is satisfied, and the finished products processed as the result of the processing of the facility elements are output to the output destination after completion of operations of the operation elements and acquires the result of the simulation processing.

In the computation of this simulation processing, simulated computation processing is performed so that, for example, the parts we1 (Body) forged by the facility element A (forging machine) are stored in the part buffers of the facility elements D and E (welding machine), the parts we2 (Side) forged by the facility elements B and C (forging machine) are stored in the part buffers of the facility elements D and E (welding machine), parts (two parts we2 (Side) and one part we1 (Body) are consumed at the time when the triggering condition of the facility element D (welding machine) or the facility element E (welding machine) (the time when two parts we2 and one part we1 are stored in the part buffers), the facility element D (welding machine) or the facility element E (welding machine) executes an operation (welding operation) to generate an intermediate product (part we3) in which the side part (Side) and the body (Body) are welded, and the intermediate product (part we3, product) is output to the facility elements F and G (pressure resistance inspection machine) defined as the next process. When a plurality of facility elements is set in the same operation element, the triggering conditions of the facility elements are determined individually, and for example, the products are preferentially output to a facility element having the larger free capacity than the capacities (part buffers) of the other facility elements, and a facility element having reached the triggering condition is operated first. Production can be simulated by performing computation so that the facility elements execute such processing in parallel.

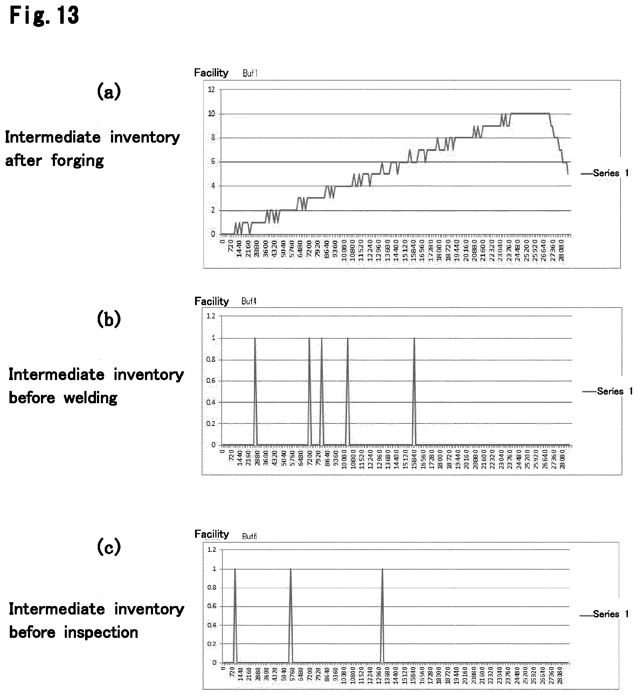

Then, in the computation of this simulation processing, various kinds of analysis can be performed by recording the state change in each facility element in the operation log database 38 so as to correspond to the time such as the elapsed time from the simulation start time. In this example, for example, the time when the part we1 (Body) forged by the facility element A (forging machine) is stored in the part buffers of the facility elements D and E (welding machine), the time when the part we2 (Side) forged by the facility elements B and C (forging machine) is stored in the part buffers of the facility elements D and E (welding machine), the time when the facility element D (welding machine) or the facility element E (welding machine) consumes two parts we2 (Side) and one part we1 (Body) and starts generating the part we3 (intermediate product), and the time when the facility element D (welding machine) or the facility element E (welding machine) completes generation of the part we3 (intermediate product) are recorded and stored in the operation log database 38 so as to correspond to respective states. FIG. 13 shows a graph showing the temporal progress of the intermediate inventory based on the log recorded in the operation log database 38. The graph of FIG. 13 corresponds to the content that the computation control unit 2 that cooperates with the production design support program or the simulation processing unit 213 outputs from the output unit 5 and presents to the user as the result of the simulation processing corresponding to the problem space. In this way, it is possible to grasp the number of parts in the part buffer held by each facility element, that is, the temporal progress of the intermediate inventory, and as another example, the temporal progress of the operation rate of each facility element can be grasped by making a graph in the same way.

By presenting the optimum solution or the optimum solution group obtained by the learning process to the user and presenting the result of the simulation processing corresponding to the problem space to the user, for example, the user can clearly grasp the related inventory state and inventory progress with respect to the solution for the reduction of the inventory cost obtained by the learning process. That is, it is possible to eliminate the black-boxing of the solution due to the learning process based on artificial intelligence, and to provide the user with sufficient judgment material about the solution.

### [Example of second embodiment]

Next, an example in which the production design support device 1 of the second embodiment is applied to a production process for manufacturing a high-pressure gas container as a product will be described. This example is basically the same as the example of the first embodiment shown in FIGS. 6 to 13. That is, based on the same configuration and processing as in the example of the first embodiment, the learning processing unit 212 executes an analysis process of acquiring an optimum solution or an optimum solution group of the production design while correcting and updating the learned model using the generated problem space stored in the problem space storage unit 35 as a boundary condition and outputs the acquired optimum solution group from the output unit 5 and presents the same to the user. Moreover, the simulation processing unit 213 executes simulation processing on the components of one or a plurality of production line models which is the basis of the problem space so that the facility element executes an operation when the triggering condition of the operation element information of the operation element associated with the facility element by the link information is satisfied, and the execution result is output to an output destination after completion of operation of the operation element information of the operation element, acquires the result of the simulation processing, outputs the result of the simulation processing corresponding to the problem space from the output unit 5, and presents the same to the user.

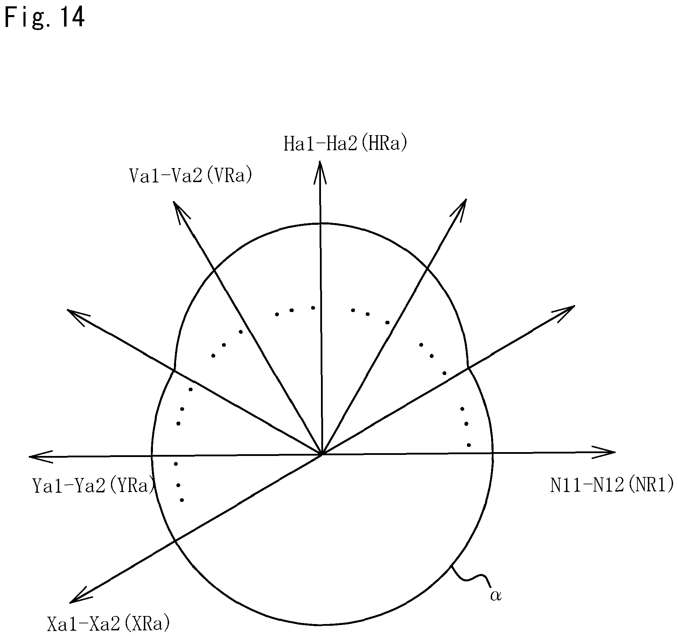

When the result of the simulation processing includes combinations of a production line model in which the temporal fluctuation of the intermediate inventory of the part we1 is large and the values of variable parameters of the production line model, in order to suppress a rapid increase in the inventory corresponding to a rapid increase in the working capital, the upper threshold of the fluctuation rate in a predetermined period is set for the part we1 or a plurality of parts including the part we1 according to the input from the input unit 4 and the threshold is stored in the predetermined storage area of the storage unit 3 of the production design support device 1. This threshold corresponds to the additional condition corresponding to the result of the simulation processing. The learning processing unit 212 executes a process of acquiring a narrowed optimum solution or a narrowed optimum solution group on the basis of combinations of the production line model in which the fluctuation rate of the inventory in a predetermined period is lower than the upper threshold and the values of the variable parameters of the production line model according to the additional condition corresponding to the result of the simulation processing using the problem space stored in the problem space storage unit 35 as the boundary condition. At this time, according to the additional condition corresponding to the result of the simulation processing, a compressed space α in the problem space of the multidimensional solution space is the substantial problem space or the substantial boundary condition corresponding to the process of acquiring the narrowed optimum solution or the narrowed optimum solution group (see FIG. 14). The learning processing unit 212 presents the acquired narrowed optimum solution or narrowed optimum solution group to the user, for example, with the content of the combinations of the production line model PL3 of FIG. 12 and the values of the variable parameters of the production line model PL3.

In this way, the configuration and internal behavior of the production line can be evaluated again, the accuracy of the learning processing unit 212 based on artificial intelligence can be complemented, and a narrowed optimum solution or a narrowed optimum solution group with higher accuracy can be obtained.

### [Example of third embodiment]

Next, an example in which the production design support device 1 of the third embodiment is applied to a production process for manufacturing a high-pressure gas container as a product will be described. This example basically corresponds to the example of the first embodiment shown in FIGS. 6 to 11, and executes the same process as in the example of the first embodiment until the problem space generation unit 211 generates the problem space and stores the same in the problem space storage unit 35.

The simulation processing unit 213 executes simulation processing on the components of one or a plurality of production line models which is the basis of a problem space corresponding to a part of the problem space so that the facility element executes an operation when the triggering condition of the operation element information of the operation element associated with the facility element by the link information is satisfied, and the execution result is output to an output destination after completion of operation of the operation element information of the operation element, acquires the result of the simulation processing, and stores the result of the simulation processing in the predetermined storage area of the storage unit 3.

Further, the upper threshold of the fluctuation rate of the inventory in a predetermined period is set for an intermediate part such as the part we1 and the like in the predetermined storage area of the storage unit 3 of the production design support device 1. In this state, when the characteristic condition acquisition unit 214 detects a fluctuation rate of the inventory of the intermediate inventory exceeding this threshold, the characteristic condition acquisition unit 214 acquires a condition that the fluctuation rate of the inventory of the part is within the threshold as the characteristic condition and stores the characteristic condition in the characteristic condition storage unit 39 (see FIG. 13).

Alternatively, as another example, assuming an example in which a resolution is not set in the changeable specification of the facility element information required in the example of the facility element information of FIG. 8, an example in which a resolution is not set in the changeable specification of the operation element information required in the example of the operation element information of FIG. 9, or both examples, in a state in which a threshold range of the degree of difference or the fluctuation rate of a required index of the result of the simulation processing such as the degree of difference of the graph (see FIG. 13) of the temporal progress of the fluctuation of the intermediate inventory is set in the predetermined storage area of the storage unit 3 of the production design support device 1, the characteristic condition acquisition unit 214 acquires a combination of variable parameters corresponding to the results of two simulation processes in which the degree of difference or the fluctuation rate of a required index such as the degree of difference of a temporal progress graph showing the fluctuation in the intermediate inventory in the results of the plurality of simulation processes is within the threshold and the values of the variable parameters are the closest, acquires a characteristic condition in which the difference between the values of variable parameters in the combination of the two variable parameters is used as the resolution of the variable parameters, and stores the characteristic condition in the characteristic condition storage unit 39. That is, by the process of acquiring this characteristic condition, the required resolutions XRa, YRa, NR1, and the like, which are additional information of the problem space, are acquired (see FIGS. 8 and 9).

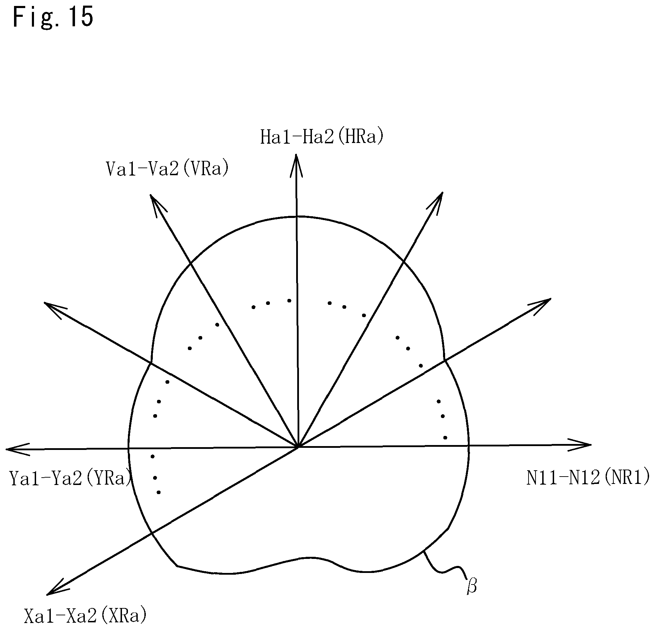

Then, the learning processing unit 212 executes an analysis process of acquiring an optimum solution or an optimum solution group of the production design while correcting and updating the learned model or the learning model of the learning data storage unit 36 according to the characteristic condition using the problem space as a boundary condition. At this time, according to the characteristic condition corresponding to the result of the simulation processing, a compressed space β in the problem space of the multidimensional solution space is the substantial problem space or the substantial boundary condition corresponding to the process of acquiring the optimum solution or the optimum solution group (see FIG. 15). The learning processing unit 212 presents the acquired optimum solution or optimum solution group to the user, for example, with the content of the combinations of the production line model PL3 of FIG. 12 and the values of the variable parameters of the production line model PL3.

In this way, the configuration and internal behavior of the production line can be evaluated again, and a reliable optimum solution or narrowed optimum solution group can be obtained efficiently.

### [Scope of inclusion of invention disclosed in present specification]

In addition to the inventions, embodiments, and examples listed as inventions, the inventions disclosed in the present specification includes, within an applicable range, inventions specified by changing these partial contents to other contents disclosed in the present specification, inventions specified by adding other contents disclosed in the present specification to these contents, or inventions specified by deleting these partial contents to the extent that partial effects are obtained and making them into a higher concept. The inventions disclosed in the present specification also include the following modifications and additional contents.

For example, in the first to third embodiments, the computation control unit 2 outputs the acquired optimum solution, the optimum solution group, the narrowed optimum solution group, and the result of the simulation processing from the output unit 5 and presents the same to the user. However, it may be ideal that a communication unit is provided in the production design support device 1, and the computation control unit 2 transmits the acquired optimum solution, the optimum solution group, the narrowed optimum solution group, and the result of the simulation processing to a computer terminal connected by communication and presents the results to the user via the computer terminal. Alternatively, it may be ideal that both configurations are used together.

Further, it may be ideal to provide the production design support device 1, the production design support method, the production design support program, and a recording medium or a non-transitory recording medium having the program mounted thereon, having a configuration in which the first embodiment and the second embodiment are combined, a configuration in which the second embodiment and the third embodiment are combined, a configuration in which the first embodiment and the third embodiment are combined, or a configuration in which the first, second, and third embodiments are combined.

Further, it is ideal that the production design support device, the production design support method or the production design support program, and the recording medium having the method or program mounted thereon are used for supporting a production design of tangible products. However, it may be preferable that they are applied to creating intangible products having added value such as value chains in an operation in which a variety of defined tasks such as the design, management, and scheduling of civil engineering work process, the design and management of construction process, scheduling of truck transportation, air traffic control, the design and supervision of food manufacturing process, agricultural product processing process, the design of fishery processing process, the design of livestock processing process, the menu design of chain restaurants, warehouse work planning, and office paperwork, are carried out in association with multiple elements.

### [Industrial Applicability]

The present invention can be used, for example, when optimizing the design of a production line in a factory in the manufacturing industry.

### [Reference Signs List]

- 1: Production design support device
- 2: Computation control unit
- 21: Production design support processing unit
- 211: Problem space generator
- 212: Learning processing unit
- 213: Simulation processing unit
- 214: Characteristic condition acquisition unit
- 3: Storage unit
- 31: Production design support program storage unit
- 311: Problem space generation program storage unit
- 312: Learning processing program storage unit
- 313: Simulation processing program storage unit
- 314: Characteristic condition acquisition program storage unit
- 32: Facility element information storage unit
- 33: Operation element information storage unit
- 34: Production line model storage unit
- 35: Problem space storage unit
- 36: Learning data storage unit
- 37: Screen data storage unit
- 38: Operation log database
- 39: Characteristic condition storage unit
- 4: Input unit
- 5: Output unit
- α, β: Compressed space

## Claims

1. A production design support device comprising:
a facility element information storage unit that stores facility element information composed of specifications of facility elements;
an operation element information storage unit that stores operation element information composed of specifications of operation elements including triggering conditions of necessary operation elements and an output destination after completion of operation; and
a production line model storage unit that stores a production line model defined by a combination of components including link information that associates the facility element and the operation element, the facility element information, and the operation element information, or basic data of the production line model including a combination of operation elements and facility elements for which the link information can be set as the component, wherein
a plurality of pieces of information among changeable specifications in the facility element information, changeable specifications in the operation element information, and changeable link information are set as variable parameters of a plurality of independent variables to generate a problem space composed of dimensional axes corresponding to the variable parameters, and
a learning processing unit executes an analysis process of acquiring an optimum solution or an optimum solution group of a production design using the problem space as a boundary condition.

2. The production design support device according to claim 1, wherein
the production line model storage unit stores a plurality of production line models defined by a combination of the components corresponding to only a combination of the facility elements and the operation elements that can be executed in a production line,
the changeable specifications in the facility element information are set as variable parameters of the plurality of independent variables, the changeable specifications in the operation element information are set as the variable parameters of the plurality of independent variables, or both are set as the variable parameters of the plurality of independent variables to generate a problem space composed of dimensional axes corresponding to the variable parameters.

3. The production design support device according to claim 1, wherein
the changeable specifications in the facility element information, the changeable specifications in the operation element information, and the changeable link information are set as the variable parameters of the plurality of independent variables to generate a problem space composed of dimensional axes corresponding to the variable parameters.

4. The production design support device according to any one of claims 1 to 3, wherein
production plan information having information on a finished product and changeable specifications are stored in a storage unit, and
changeable specifications in the production plan information are set as variable parameters to generate a problem space composed of dimensional axes corresponding to the variable parameters.

5. The production design support device according to any one of claims 1 to 4, wherein
a resolution is set to necessary changeable specifications in the facility element information, and
changeable specifications in the facility element information, to which the resolution is set, are set as variable parameters of independent variables to generate the problem space having the resolutions of the changeable specifications in the facility element information as additional information.

6. The production design support device according to any one of claims 1 to 5, wherein
a resolution is set to necessary changeable specifications in the operation element information, and
changeable specifications in the operation element information, to which the resolution is set, are set as variable parameters of independent variables to generate the problem space having the resolutions of the changeable specifications in the operation element information as additional information.

7. The production design support device according to any one of claims 1 to 6, wherein
the learning processing unit acquires an optimum solution or an optimum solution group using the problem space as a boundary condition and presents the optimum solution or the optimum solution group to the user,
simulation processing is executed on the components of the production line model which is the basis of the problem space so that the facility element executes an operation when the triggering condition of the operation element information of the operation element associated with the facility element by the link information is satisfied and the execution result is output to an output destination after completion of operation of the operation element information of the operation element, and
the result of the simulation processing corresponding to the problem space is presented to a user.

8. The production design support device according to any one of claims 1 to 7, wherein
the learning processing unit acquires the optimum solution group using the problem space as a boundary condition,
simulation processing is executed on the components of the production line model which is the basis of the problem space so that the facility element executes an operation when the triggering condition of the operation element information of the operation element associated with the facility element by the link information is satisfied and the execution result is output to an output destination after completion of operation of the operation element information of the operation element, and
the learning processing unit executes a process of acquiring a narrowed optimum solution or a narrowed optimum solution group according to an additional condition corresponding to the result of the simulation processing using the problem space as a boundary condition.

9. The production design support device according to any one of claims 1 to 8, wherein
simulation processing is executed on the components of the production line model which is the basis of the problem space so that the facility element executes an operation when the triggering condition of the operation element information of the operation element associated with the facility element is satisfied and the execution result is output to an output destination after completion of operation of the operation element information of the operation element,
a characteristic condition of the problem space is acquired on the basis of the result of the simulation processing corresponding to at least a part of the problem space, and
the learning processing unit executes an analysis process of acquiring an optimum solution or an optimum solution group of a production design according to the characteristic condition using the problem space as a boundary condition.

10. A production design support method executed by a computer, comprising:
storing facility element information composed of specifications of facility elements;
storing operation element information composed of specifications of operation elements including triggering conditions of necessary operation elements and an output destination after completion of operation;
storing a production line model defined by a combination of components including link information that associates the facility element and the operation element, the facility element information, and the operation element information, or basic data of the production line model including a combination of operation elements and facility elements for which the link information can be set as the component;
setting a plurality of pieces of information among changeable specifications in the facility element information, changeable specifications in the operation element information, and changeable link information as variable parameters of a plurality of independent variables to generate a problem space composed of dimensional axes corresponding to the variable parameters; and
causing a learning processing unit to execute an analysis process of acquiring an optimum solution or an optimum solution group of a production design using the problem space as a boundary condition.

11. A production design support program for causing a computer to function as a production design support device,
the program causing the computer to execute:
storing facility element information composed of specifications of facility elements;
storing operation element information composed of specifications of operation elements including triggering conditions of necessary operation elements and an output destination after completion of operation;
storing a production line model defined by a combination of components including link information that associates the facility element and the operation element, the facility element information, and the operation element information, or basic data of the production line model including a combination of operation elements and facility elements for which the link information can be set as the component;
setting a plurality of pieces of information among changeable specifications in the facility element information, changeable specifications in the operation element information, and changeable link information as variable parameters of a plurality of independent variables to generate a problem space composed of dimensional axes corresponding to the variable parameters; and
causing a learning processing unit to execute an analysis process of acquiring an optimum solution or an optimum solution group of a production design using the problem space as a boundary condition.
